(19) **Europäisches Patentamt / European Patent Office / Office européen des brevets**

(11) **EP 3 985 871 B1**

(12) **FASCICULE DE BREVET EUROPEEN**

(45) Date de publication et mention de la délivrance du brevet:
**12.04.2023 Bulletin 2023/15**

(21) Numéro de dépôt: **21202830.2**

(22) Date de dépôt: **15.10.2021**

(51) Classification Internationale des Brevets (IPC):
**H03H 11/04** *(2006.01)* **H03H 17/02** *(2006.01)*
**H04B 1/7163** *(2011.01)*

(52) Classification Coopérative des Brevets (CPC):
**H03H 11/04; H03H 11/0422; H03H 11/0466; H03H 17/0291;** H03H 2011/0488

(54) **FILTRE COUPE-BANDE EFFECTUANT UNE INTÉGRATION LORS DE PLUSIEURS FENÊTRÉES TEMPORELLES SUCCESSIVES, DISPOSITIF DE FILTRAGE PASSE-BANDE, SYSTÈME DE DÉTECTION DE FRÉQUENCE ET PROCÉDÉ DE TRAITEMENT ASSOCIÉS**

BANDSPERRFILTER WELCHES WÄHREND MEHRERER AUFEINANDERFOLGENDER ZEITFENSTER INTEGRIERT, BANDPASSFILTERVORRICHTUNG, FREQUENZERFASSUNGSSYSTEM UND ENTSPRECHENDES VERARBEITUNGSVERFAHREN

BAND-STOP FILTER PERFORMING INTEGRATION DURING A PLURALITY OF SUCCESSIVE TIME WINDOWS , BAND-PASS FILTERING DEVICE, FREQUENCY DETECTION SYSTEM AND ASSOCIATED PROCESSING METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.10.2020 FR 2010662**

(43) Date de publication de la demande:
**20.04.2022 Bulletin 2022/16**

(73) Titulaire: **COMMISSARIAT À L'ÉNERGIE ATOMIQUE ET AUX ÉNERGIES ALTERNATIVES**
**75015 Paris (FR)**

(72) Inventeur: **MASSON, Gilles**
**38054 Grenoble Cedex 9 (FR)**

(74) Mandataire: **Lavoix**
**2, place d'Estienne d'Orves**
**75441 Paris Cedex 09 (FR)**

(56) Documents cités:
**US-A1- 2008 007 326 US-A1- 2009 134 938**
**US-A1- 2020 052 730 US-B2- 9 407 482**

**Description**

La présente invention concerne un filtre électronique coupe-bande, apte à recevoir un signal d'entrée et à délivrer un signal filtré présentant, en une fréquence de coupure, une amplitude atténuée par rapport à celle du signal d'entrée.

L'invention se rapporte également à un dispositif électronique de filtrage passe-bande comprenant un tel filtre électronique coupe-bande ; à un système de détection de fréquence comprenant un tel dispositif électronique de filtrage passe-bande ; à un récepteur radio comprenant un tel système de détection de fréquence ; et à un procédé associé de traitement d'un signal numérique mis en oeuvre par ordinateur.

L'invention concerne le domaine des filtres électroniques pour appliquer une atténuation à un signal reçu en entrée, notamment à l'intérieur d'une bande de fréquences pour un filtre coupe-bande, ou en dehors d'une bande de fréquences pour un filtre passe-bande.

L'invention concerne également le domaine de la réception radiofréquence, et en particulier de l'utilisation de tels filtres électroniques en réception radiofréquence. Les applications visées sont alors par exemple de détecter la présence d'une onde radiofréquence de manière sélective parmi d'autres ondes et/ou de décoder l'information portée par une onde radiofréquence, avec par exemple un codage en amplitude, en fréquence et en phase.

On connait un filtre coupe-bande (de l'anglais *notch filter*) du type précité, aussi appelé filtre stop-bande, ou encore filtre réjecteur de bande, un tel filtre visant à empêcher le passage d'une plage de fréquences du signal, typiquement autour d'une fréquence prédéfinie, appelée fréquence de coupure.

On connait également un dispositif électronique de filtrage passe-bande du type précité, aussi appelé filtre passe-bande (de l'anglais *bandpass filter*), un tel filtre visant à conserver seulement une bande de fréquences du signal autour d'une fréquence cible et à empêcher le passage du signal en dehors de cette bande de fréquences.

Le document US 9,407,482 B2 et l'article « Tunable N-Path RF Front-end Filter with an Adaptive Integrated Notch for FDDICo-Existence » de Hasan, IEEE 2012, présente une architecture de filtre passe-bande sélectif, c'est-à-dire à réjection élevée, via une combinaison d'un filtre passe-bande et d'un filtre stop-bande permettant d'obtenir une meilleure sélectivité. Les filtres passe-bande et stop-bande utilisés sont des filtres à capacité commutée, également appelés filtres de type N-path (de l'anglais *N-path filter*), où N est le nombre de commutateurs mis en parallèle.

Une telle architecture avec la combinaison de ces deux filtres permet d'améliorer la réjection du filtre en une fréquence précise, proche de la fréquence du filtre passe-bande.

L'article « Widely Tunable 4th Order Switched Gm-C Band-Pass Filter Based on N-Path Filters » de Darvishi, IEEE 2012, présente également une architecture de filtre passe-bande à réjection élevée, via la combinaison de deux filtres passe-bande d'ordre 2 et décalés en fréquence, afin d'obtenir un filtre passe-bande d'ordre 4. Les filtres passe-bande utilisés sont également des filtres de type N-path.

Cependant, les filtres N-path présentent des inconvénients limitant leur performance en terme de génération d'horloges avec une limitation en fréquence des horloges utilisées pour subdiviser la période du signal à détecter, et la nécessité également que les horloges soient non-recouvrantes pour ne pas dégrader la sélectivité, le gain et la linéarité, ce qui réduit encore leur période d'activité, et augmente la complexité, l'imprécision et le désappariement, dégradant alors les performances d'un tel filtre. Cette limitation de performance se traduit également sous forme de pertes d'insertion, la résistance des commutateurs limitant la réjection hors bande.

Cette résistance peut alors être réduite en augmentant le nombre N de commutateurs mis en parallèle, mais ceci se fait alors au détriment d'une augmentation de la consommation électrique et d'une réduction de la fréquence maximale d'utilisation. Ces performances limitées concernent également la sélectivité qui est, d'une part, liée à la capacité de filtrage qui doit être augmentée, et d'autre part liée à l'ordre du filtre qui est limité intrinsèquement à l'ordre 2.

Afin d'augmenter l'ordre du filtre, et ce faisant sa sélectivité, il est par exemple nécessaire de cascader plusieurs filtres de type N-path, comme décrit dans l'article de Darvishi, mais ceci entraîne alors également une augmentation de la consommation électrique et une limitation de la fréquence d'utilisation.

En outre, ces architectures de filtre passe-bande nécessitent l'intégration d'un séparateur (de l'anglais *splitter*) en entrée afin d'orienter le signal d'entrée vers les deux filtres utilisés en combinaison, et également d'un combineur (de l'anglais *combiner*) en sortie afin d'effectuer la combinaison des signaux filtrés issus de chacun des filtres. Ces séparateurs et combineurs limitent alors encore les performances du filtre passe-bande, et engendrent aussi une consommation électrique supplémentaire.

Le but de l'invention est alors de proposer un filtre électronique coupe-bande, et un dispositif électronique associé de filtrage passe-bande, permettant de réduire la consommation électrique, tout en étant sélectif et en offrant une réjection élevée.

A cet effet, l'invention a pour objet un filtre électronique coupe-bande du type précité, comprenant :

- un module d'intégration configuré pour effectuer une intégration du signal d'entrée lors de plusieurs fenêtres temporelles successives, chaque fenêtre temporelle débutant en un instant temporel initial respectif et ayant une durée sensiblement égale à l'inverse de la fréquence de coupure, les instants temporels initiaux d'au moins deux fenêtres distinctes étant séparés d'un décalage temporel de valeur supérieure ou égale à une durée prédéfinie de référence, telle que l'inverse de la fréquence de coupure, chaque intégration du signal d'entrée lors d'une fenêtre temporelle respective résultant en un signal intermédiaire respectif,

- un module de sommation connecté en sortie du module d'intégration et configuré pour sommer les signaux intermédiaires issus du module d'intégration, le signal filtré étant fonction de la somme desdits signaux intermédiaires.

Ainsi, le filtre électronique coupe-bande selon l'invention est apte à mettre en oeuvre le filtrage du signal d'entrée en seulement quelques périodes du signal d'entrée, ce qui permet de limiter la consommation électrique et d'offrir un meilleur débit, tout en continuant à offrir une sélectivité élevée.

En outre, les instants temporels initiaux des fenêtres temporelles successives sont aptes à être générés avec des horloges de commande ayant des périodes d'activité de l'ordre de la période de la fréquence de coupure. Ceci permet alors d'augmenter la valeur de cette fréquence de coupure et d'utiliser alors le filtre coupe-bande selon l'invention dans une application de filtrage radiofréquence d'un récepteur radio, notamment une application de filtre de canal radiofréquence, également appelé filtre de canal RF (de l'anglais *RF channel filte*r), c'est-à-dire une application de filtre direct en radiofréquence, typiquement avant une conversion vers une fréquence plus basse (de l'anglais *down-conversion*).

Suivant d'autres aspects avantageux de l'invention, le filtre électronique coupe-bande comprend une ou plusieurs des caractéristiques suivantes, prises isolément ou suivant toutes les combinaisons techniquement possibles :

- le module d'intégration est configuré pour effectuer l'intégration du signal d'entrée lors de No premières fenêtres temporelles successives, puis lors de Nb deuxièmes fenêtres temporelles successives, No et Nb étant chacun un nombre entier supérieur ou égal à 2, les instants temporels initiaux des No premières fenêtres étant tous inclus dans une première période temporelle de durée sensiblement égale à la durée de référence, et les instants temporels initiaux des Nb deuxièmes fenêtres étant tous postérieurs à la première période temporelle ;

les instants temporels initiaux des No premières fenêtres étant de préférence régulièrement répartis au cours de la première période temporelle ;
les instants temporels initiaux des Nb deuxièmes fenêtres étant de préférence régulièrement répartis au cours d'une deuxième période temporelle, postérieure à la première période temporelle ;
la deuxième période temporelle étant de préférence encore de durée sensiblement égale à la durée de référence ;

- un module d'une fonction de transfert associée à l'intégration du signal d'entrée lors d'une fenêtre temporelle respective vérifie l'équation suivante :

$$|G(f)| = \frac{\sqrt{2(1 - \cos(2\pi f T_{int}))}}{\dfrac{f}{F_{int}}}$$

où G représente le gain et f la fréquence,
$T_{int}$ représente la durée de la fenêtre temporelle respective ; et
$F_{int}$ vérifie l'équation suivante :

$$F_{int} = \frac{g_m}{2\pi C_{int}}$$

avec $g_m$ représentant une transconductance de l'intégration, et.
$C_{int}$ représentant une capacité de l'intégration ;

- le module d'intégration comporte au moins une unité d'intégration, chaque unité d'intégration étant connectée en entrée du module de sommation et configurée pour effectuer une intégration du signal d'entrée lors d'au moins une fenêtre temporelle ;
le module d'intégration comportant de préférence plusieurs unités d'intégration agencées en parallèle les unes des autres, chacune étant configurée pour effectuer une intégration du signal d'entrée lors d'une fenêtre temporelle respective ;

- le module de sommation est un module numérique, et le module d'intégration comporte au moins un convertisseur analogique-numérique, le signal d'entrée étant un signal analogique ;

  chaque unité d'intégration comportant de préférence un étage analogique de conversion, un étage moyenneur et un convertisseur analogique-numérique, et
  un convertisseur analogique-numérique avec registre à approximations successives formant de préférence encore l'étage moyenneur et le convertisseur analogique-numérique ; et

- le module d'intégration et le module de sommation sont chacun un module analogique, le signal d'entrée étant un signal analogique.

L'invention a également pour objet un dispositif électronique de filtrage passe-bande, apte à recevoir un signal d'entrée et à délivrer un signal de sortie présentant, en dehors d'une bande de fréquences centrée autour d'une fréquence cible, une amplitude atténuée par rapport à celle du signal d'entrée, le dispositif comprenant :

- un premier filtre coupe-bande, apte à recevoir le signal d'entrée et à délivrer un premier signal filtré présentant, en une première fréquence de coupure, une amplitude atténuée par rapport à celle du signal d'entrée, la première fréquence de coupure étant sensiblement égale à la fréquence cible,
- un deuxième filtre coupe-bande, apte à recevoir le signal d'entrée et à délivrer un deuxième signal filtré présentant, en une deuxième fréquence de coupure, une amplitude atténuée par rapport à celle du signal d'entrée, la deuxième fréquence de coupure étant distincte de la première fréquence de coupure, la deuxième fréquence de coupure étant strictement inférieure ou bien strictement supérieure à la fréquence cible,
- un module de génération connecté en sortie des premier et deuxième filtres coupe-bande et configuré pour générer le signal de sortie à partir d'une combinaison des premier et deuxième signaux filtrés,

au moins l'un, de préférence chacun, des premier et deuxième filtres coupe-bande étant tel que défini ci-dessus.
Ce dispositif de filtrage passe-bande selon l'invention présente les avantages décrits ci-dessus pour le filtre coupe-bande selon l'invention, au moins l'un, et de préférence chacun, des premier et deuxième filtres coupe-bande étant un filtre coupe-bande tel que défini ci-dessus.
En outre, de par les deux canaux distincts correspondant respectivement au premier filtre coupe-bande et au deuxième filtre coupe-bande, le dispositif de filtrage passe-bande selon l'invention ne nécessite ni de séparateur en entrée, le dispositif de filtrage passe-bande présentant une impédance d'entrée suffisamment élevée ; ni de combineur en sortie lorsque la génération du signal de sortie à partir de la combinaison des premier et deuxième signaux filtrés est effectuée numériquement. Ceci permet alors de réduire encore la consommation électrique, et d'avoir également un circuit électronique d'implémentation dudit dispositif de filtrage passe-bande présentant une moindre surface occupée.
L'invention a aussi pour objet un dispositif électronique de filtrage passe-bande, apte à recevoir un signal d'entrée et à délivrer un signal de sortie présentant, en dehors d'une bande de fréquences centrée autour d'une fréquence cible, une amplitude atténuée par rapport à celle du signal d'entrée, le dispositif comprenant :

- un filtre coupe-bande, apte à recevoir le signal d'entrée et à délivrer un signal filtré présentant, en une fréquence de coupure, une amplitude atténuée par rapport à celle du signal d'entrée,
- un module de commande configuré pour :

  + commander le filtre coupe-bande avec la fréquence de coupure égale à l'une parmi une première fréquence de coupure et une deuxième fréquence de coupure, et mémoriser le signal obtenu parmi un premier signal filtré associé à la première fréquence de coupure et un deuxième signal filtré associé à la deuxième fréquence de coupure, la première fréquence de coupure étant sensiblement égale à la fréquence cible, la deuxième fréquence de coupure étant distincte de la première fréquence de coupure, la deuxième fréquence de coupure étant strictement inférieure ou bien strictement supérieure à la fréquence cible ; et
  + commander ensuite le filtre coupe-bande avec la fréquence de coupure égale à l'autre parmi la première fréquence de coupure et la deuxième fréquence de coupure, afin d'obtenir l'autre signal parmi le premier signal filtré et le deuxième signal filtré,

- un module de génération connecté en sortie du module de commande et configuré pour générer le signal de sortie à partir d'une combinaison des premier et deuxième signaux filtrés,

le filtre coupe-bande étant tel que défini ci-dessus.
Suivant d'autres aspects avantageux de l'invention, le dispositif électronique de filtrage passe-bande comprend une ou plusieurs des caractéristiques suivantes, prises isolément ou suivant toutes les combinaisons techniquement possibles :

- la deuxième fréquence de coupure est sensiblement égale à deux tiers de la fréquence cible ou bien sensiblement égale à deux fois la fréquence cible ;
- la durée prédéfinie de référence est égale à l'inverse de la fréquence cible ; et
- la combinaison des premier et deuxième signaux filtrés est une combinaison linéaire,

    la combinaison linéaire des premier et deuxième signaux filtrés vérifiant de préférence l'équation suivante :

$$Ys = E2 - K \cdot E1$$

    où Ys représente le signal de sortie,
    E1 représente le premier signal filtré,
    E2 représente le deuxième signal filtré,
    K est un nombre entier supérieur ou égal à 1 ;
    K étant de préférence une puissance de 2 et s'écrivant alors :

$$K = 2^P$$

    avec P entier positif.

L'invention a également pour objet un système de détection de fréquence, notamment pour récepteur radio, le système comprenant :

- un dispositif électronique de filtrage passe-bande, apte à recevoir un signal d'entrée et à délivrer un signal de sortie présentant, en dehors d'une bande de fréquences centrée autour d'une fréquence cible, une amplitude atténuée par rapport à celle du signal d'entrée, et
- un dispositif électronique de pilotage, apte à faire varier la valeur de la fréquence cible du dispositif de filtrage passe-bande jusqu'à détection d'une fréquence caractéristique du signal d'entrée, la fréquence caractéristique correspondant alors à la valeur courante de la fréquence cible,

le dispositif électronique de filtrage passe-bande étant tel que défini ci-dessus.
L'invention a également pour objet un récepteur radio comprenant un système de détection de fréquence, le système de détection de fréquence étant tel que défini ci-dessus.
L'invention a aussi pour objet un procédé de traitement d'un signal numérique d'entrée, le signal numérique d'entrée étant apte à être fourni par un convertisseur analogique-numérique connecté en sortie d'un capteur apte à recevoir un signal analogique d'entrée, le procédé étant mis en oeuvre par ordinateur et comprenant :

- une étape de filtrage coupe-bande du signal numérique d'entrée en un signal numérique filtré, le signal numérique filtré présentant, en une fréquence de coupure, une amplitude atténuée par rapport à celle du signal numérique d'entrée,

l'étape de filtrage coupe-bande comportant :

    + une intégration du signal numérique d'entrée lors de plusieurs fenêtres temporelles successives, chaque fenêtre temporelle débutant en un instant temporel initial respectif et ayant une durée sensiblement égale à l'inverse de la fréquence de coupure, les instants temporels initiaux d'au moins deux fenêtres distinctes étant séparés d'un décalage temporel de valeur supérieure ou égale à une durée prédéfinie de référence, telle que l'inverse de la fréquence de coupure, chaque intégration du signal numérique d'entrée lors d'une fenêtre temporelle respective résultant en un signal numérique intermédiaire respectif, et
    + une sommation des signaux numériques intermédiaires, le signal numérique filtré étant fonction de la somme desdits signaux numériques intermédiaires.

Suivant d'autres aspects avantageux de l'invention, le procédé de traitement comprend une ou plusieurs des caractéristiques suivantes, prises isolément ou suivant toutes les combinaisons techniquement possibles :

- le procédé comprend un processus de filtrage passe-bande du signal numérique d'entrée en un signal numérique de sortie, le signal numérique de sortie présentant, en dehors d'une bande de fréquences centrée autour d'une fréquence cible, une amplitude atténuée par rapport à celle du signal numérique d'entrée, le processus de filtrage passe-bande comportant :

+ une mise en oeuvre initiale de l'étape de filtrage coupe-bande avec la fréquence de coupure égale à l'une parmi une première fréquence de coupure et une deuxième fréquence de coupure, la première fréquence de coupure étant sensiblement égale à la fréquence cible, la deuxième fréquence de coupure étant distincte de la première fréquence de coupure, la deuxième fréquence de coupure étant strictement inférieure ou bien strictement supérieure à la fréquence cible ;
+ une étape de mémorisation du signal obtenu parmi un premier signal numérique filtré associé à la première fréquence de coupure et un deuxième signal numérique filtré associé à la deuxième fréquence de coupure, et
+ une mise en oeuvre ultérieure de l'étape de filtrage coupe-bande avec la fréquence de coupure égale à l'autre parmi la première fréquence de coupure et la deuxième fréquence de coupure, afin d'obtenir l'autre signal parmi le premier signal numérique filtré et le deuxième signal numérique filtré,
+ une étape de génération du signal numérique de sortie à partir d'une combinaison des premier et deuxième signaux numériques filtrés.

- le procédé comprend plusieurs itérations du processus de filtrage passe-bande pour différentes valeurs successives de la fréquence cible jusqu'à détection d'une fréquence caractéristique du signal d'entrée, la fréquence caractéristique correspondant alors à une valeur courante de la fréquence cible.

Ces caractéristiques et avantages de l'invention apparaîtront plus clairement à la lecture de la description qui va suivre, donnée uniquement à titre d'exemple non limitatif, et faite en référence aux dessins annexés, sur lesquels :

- la figure 1 est une représentation schématique d'un filtre électronique coupe-bande selon l'invention, le filtre coupe-bande comportant un module d'intégration d'un signal d'entrée lors de plusieurs fenêtres temporelles successives, un module de génération de fronts d'horloge correspondant à des instants temporels initiaux et finaux des fenêtres temporelles successives, et un module de sommation connecté en sortie du module d'intégration ;
- la figure 2 est une représentation schématique des fenêtres temporelles successives, mises en oeuvre par le module d'intégration de la figure 1 ;

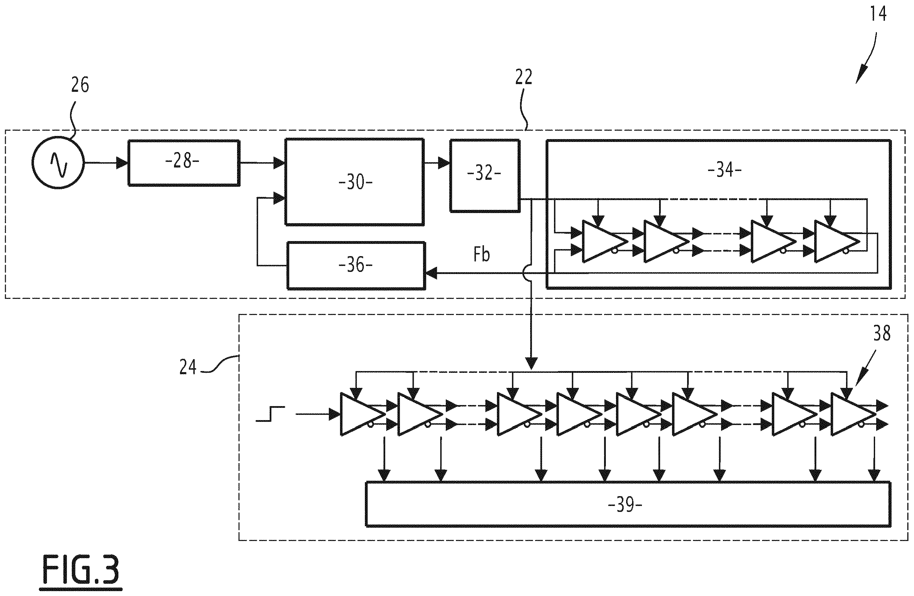

- la figure 3 est une représentation schématique du module de génération de la figure 1 ;
- la figure 4 est un organigramme de mise en oeuvre du filtre coupe-bande de la figure 1, lorsque le module d'intégration comporte une unique unité d'intégration pour effectuer l'intégration du signal d'entrée lors des fenêtres temporelles successives ;
- la figure 5 est une représentation schématique d'un dispositif électronique de filtrage passe-bande selon l'invention, comportant au moins un filtre électronique coupe-bande du type de celui de la figure 1, selon un premier exemple d'implémentation ;
- la figure 6 est une représentation schématique de premières fenêtres temporelles successives pour la mise en oeuvre d'un filtre coupe-bande avec une première fréquence de coupure, et de deuxièmes fenêtres temporelles successives pour la mise en oeuvre d'un filtre coupe-bande respectif avec une deuxième fréquence de coupure ;
- la figure 7 est un ensemble de courbes illustrant des signaux simulés en sortie du dispositif de filtrage passe-bande de la figure 5 pour deux valeurs distinctes de la deuxième fréquence de coupure, et pour deux combinaisons distinctes de premier et deuxième signaux filtrés, ces signaux filtrés résultant de l'application du filtre coupe-bande à la première fréquence de coupure, et respectivement à la deuxième fréquence de coupure ;
- la figure 8 est un ensemble de courbes représentant, d'une part, une fonction de transfert du filtre coupe-bande avec la première fréquence de coupure, et d'autre part, une fonction de transfert du filtre coupe-bande avec la deuxième fréquence de coupure pour une valeur de la deuxième fréquence de coupure inférieure à une fréquence cible du dispositif de filtrage passe-bande, telle que 2/3 de la fréquence cible ;
- la figure 9 est un ensemble de courbes représentant une fonction de transfert du dispositif de filtrage passe-bande de la figure 5 avec la valeur de la deuxième fréquence de coupure inférieure à la fréquence cible et pour différentes combinaisons des premier et deuxième signaux filtrés ;
- la figure 10 est une vue analogue à celle de la figure 8 pour une valeur de la deuxième fréquence de coupure supérieure à la fréquence cible, telle que deux fois la fréquence cible ;
- la figure 11 est une vue analogue à celle de la figure 9 pour la valeur de la deuxième fréquence de coupure supérieure à la fréquence cible ;
- la figure 12 est un ensemble de courbes représentant le signal obtenu suite à l'intégration du signal d'entrée pour différentes fenêtres temporelles successives via le filtre coupe-bande avec la deuxième fréquence de coupure, ceci d'une part pour la valeur de la deuxième fréquence de coupure inférieure à la fréquence cible, et d'autre part pour la valeur de la deuxième fréquence de coupure supérieure à la fréquence cible ; ainsi que des diagrammes de constellation correspondant à ces courbes ;

- la figure 13 est une vue analogue à celle de la figure 5, selon un deuxième exemple d'implémentation ;
- la figure 14 est une vue analogue à celle de la figure 5, selon un troisième exemple d'implémentation ;
- la figure 15 représente un premier organigramme de mise en oeuvre du dispositif électronique de filtrage passe-bande selon l'invention lorsqu'il comprend des premier et deuxième filtres coupe-bande distincts et agencés en parallèle ; et un deuxième organigramme de mise en oeuvre du dispositif de filtrage passe-bande selon l'invention lorsqu'il comprend un unique filtre coupe-bande, successivement mis en oeuvre pour la première fréquence de coupure, et respectivement pour la deuxième fréquence de coupure ;
- la figure 16 représente un troisième organigramme de mise en oeuvre du dispositif électronique de filtrage passe-bande selon l'invention lorsqu'il comprend l'unique filtre coupe-bande ; et
- la figure 17 représente un organigramme d'un procédé selon l'invention de traitement d'un signal numérique.

Dans la présente description, l'expression « sensiblement égal(e) à » définit une relation d'égalité à plus ou moins 10 %, de préférence à plus ou moins 5 %.

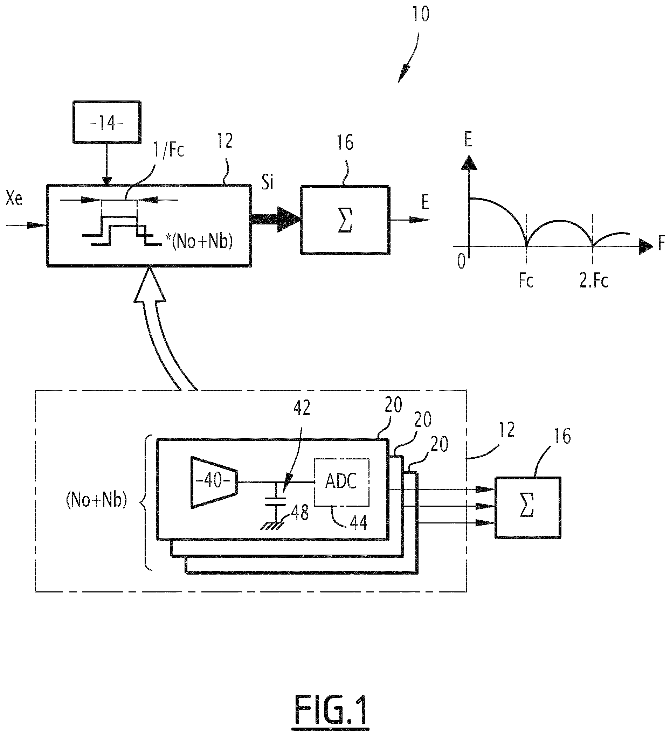

Sur la figure 1, un filtre électronique coupe-bande 10 est apte à recevoir un signal d'entrée Xe et à délivrer un signal filtré E présentant, en une fréquence de coupure Fc, une amplitude atténuée par rapport à celle du signal d'entrée Xe. Cette atténuation en la fréquence de coupure Fc est illustrée par la courbe schématique visible à la figure 1 et représentant le signal filtré E en fonction de la fréquence F.

Le filtre coupe-bande 10 (de l'anglais *notch filter*) est également appelé filtre stop-bande ou encore filtre réjecteur de bande, et est comme connu en soi aussi apte à atténuer l'amplitude du signal d'entrée Xe pour des multiples de la fréquence de coupure Fc, ainsi que schématisé sur la courbe du signal filtré E avec les atténuations d'amplitude pour les fréquences égales à Fc et 2Fc.

Le filtre coupe-bande 10 comprend un module 12 d'intégration du signal d'entrée lors de plusieurs fenêtres temporelles W1, W2 successives, chaque fenêtre temporelle W1, W2 ayant une durée sensiblement égale à l'inverse de la fréquence de coupure Fc, chaque intégration du signal d'entrée Xe lors d'une fenêtre temporelle W1, W2 respective résultant en un signal intermédiaire Si respectif.

Le filtre coupe-bande 10 comprend un module 14 de génération de fronts d'horloge correspondant à des instants temporels initiaux, et respectivement finaux, des fenêtres temporelles W1, W2 successives, le module de génération 14 étant connecté au module d'intégration 12. En variante non représentée, le module de génération est intégré au module d'intégration 12.

Le filtre coupe-bande 10 comprend un module 16 de sommation des signaux intermédiaire Si issus du module d'intégration 12, le module de sommation 16 étant connecté en sortie du module d'intégration 12.

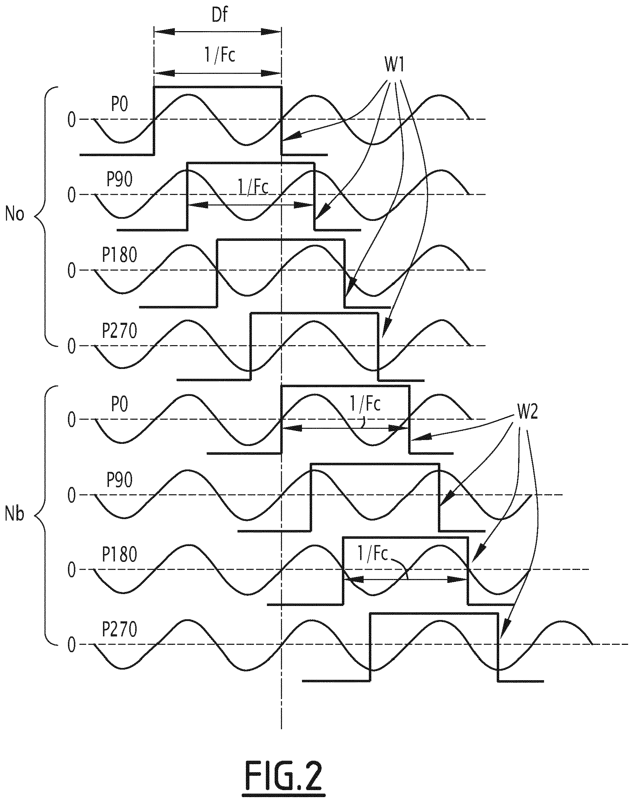

Le module d'intégration 12 est configuré pour effectuer une intégration du signal d'entrée Xe lors des fenêtres temporelles W1, W2 successives, visibles sur la figure 2, chaque fenêtre temporelle W1, W2 débutant en un instant temporel initial respectif et ayant une durée sensiblement égale à l'inverse de la fréquence de coupure Fc.

Le module d'intégration 12 est configuré en outre pour décaler temporellement les fenêtres temporelles W1, W2, les unes par rapport aux autres, les instants temporels initiaux étant alors décalés les uns par rapport aux autres, et les instants temporels initiaux d'au moins deux fenêtres temporelles W1, W2 distinctes étant en outre séparés d'un décalage temporel de valeur supérieure ou égale à une durée prédéfinie de référence Df, telle que l'inverse de la fréquence de coupure Fc.

Dans l'exemple de la figure 2, le module d'intégration 12 est configuré pour effectuer l'intégration du signal d'entrée lors de No premières fenêtres temporelles W1 successives, repérées par l'accolade No, puis lors de Nb deuxième fenêtres temporelles W2 successives, repérées par l'accolade Nb.

Les nombres No et Nb sont chacun un nombre entier supérieur ou égal à 2, de préférence compris entre 3 et 5, et de préférence égal à 4. Dans l'exemple de la figure 2, les nombres No et Nb sont tous deux égaux à 4.

Les inventeurs ont observé que plus la valeur de No, et respectivement Nb, est élevée, plus la précision du filtre coupe-bande 10 sera élevée. L'homme du métier notera toutefois que plus cette valeur du nombre No, et respectivement Nb, est élevée, plus la durée de mise en oeuvre du filtre coupe-bande 10 sera importante, et en outre plus la consommation électrique, voire la surface occupée par un circuit électronique de mise en oeuvre dudit filtre 10, sera importante. La valeur égale à 4 pour No et Nb constitue alors un compromis intéressant entre précision d'une part, et consommation électrique d'autre part.

Dans l'exemple de la figure 2, les nombres No de premières fenêtres W1 et Nb de deuxièmes fenêtres W2 sont égaux. En variante, non représentée, les nombres No et Nb sont différents.

Les instants temporels initiaux des No premières fenêtres W1 sont tous inclus dans une première période temporelle de durée sensiblement égale à la durée de référence Df, et les instants temporels initiaux des Nb deuxièmes fenêtres W2 sont tous postérieurs à la première période temporelle. Dans l'exemple de la figure 2, la durée prédéfinie de référence Df est égale à l'inverse de la fréquence de coupure Fc.

La fenêtre initiale parmi les No premières fenêtres temporelles W1 est séparée d'un décalage temporel égal à la durée prédéfinie de référence Df avec la fenêtre initiale parmi les Nb deuxième fenêtres temporelles W2, ces deux fenêtres correspondant alors typiquement aux deux fenêtres précitées qui sont séparées du décalage temporel de valeur supérieure ou égale à la durée prédéfinie de référence Df. Il en est de même entre les fenêtres successives respectives des No premières fenêtres temporelles W1 et celles des Nb deuxième fenêtres temporelles W2, dans l'exemple de la figure 2.

L'homme du métier comprendra que dans l'exemple de la figure 2, la première période temporelle correspond typiquement à la période débutant en un instant temporel initial de la fenêtre initiale parmi les No premières fenêtres temporelles W1 et se terminant à cet instant plus la durée de référence Df. Autrement dit, la première période temporelle correspond typiquement à la période de la fenêtre initiale parmi les No premières fenêtres temporelles W1.

En complément facultatif, les instants temporels initiaux des No premières fenêtres W1 sont régulièrement répartis au cours de la première période temporelle. Dans l'exemple de la figure 2, les No premières fenêtres temporelles W1 correspondent à des décalages de phase respectivement égaux à 0°, 90°, 180° et 270°, et notés respectivement P0, P90, P180 et P270. Ces décalages de phase correspondent alors à ladite répartition régulière des instants temporels initiaux, puisque le décalage d'un instant temporel à l'autre correspond à un décalage de phase de 90°, c'est-à-dire 360°/No avec No égal à 4.

En complément facultatif encore, les instants temporels initiaux des Nb deuxièmes fenêtres W2 sont tous inclus dans une deuxième période temporelle de durée sensiblement égale à la durée de référence Df et postérieure à la première période temporelle.

Selon ce complément facultatif, les instants temporels initiaux des Nb deuxièmes fenêtres W2 sont en outre de préférence régulièrement répartis au cours de la deuxième période temporelle. Dans l'exemple de la figure 2, les instants temporels initiaux des Nb deuxièmes fenêtres W2 correspondent alors à des décalages de phase respectivement égaux à 0°, 90°, 180° et 270°, et notés respectivement P0, P90, P180 et P270. De manière analogue au No premières fenêtres W1, l'homme du métier observera alors que ces décalages de phase correspondent à une répartition régulière des instants temporels initiaux des Nb deuxièmes fenêtres W2, le décalage étant égal à 90° entre deux instants initiaux successifs, soit 360°/Nb avec Nb égal à 4.

La deuxième période temporelle correspond typiquement à la période débutant en instant temporel initial associé à la fenêtre initiale parmi les Nb deuxièmes fenêtres temporelles W2 et se terminant à cet instant plus la durée de référence Df. Autrement dit, la deuxième période temporelle correspond typiquement à la période de la fenêtre initiale parmi les Nb deuxièmes fenêtres temporelles W2.

Le module d'intégration 12 est par exemple configuré pour effectuer l'intégration du signal d'entrée Xe lors d'une fenêtre temporelle W1, W2 respective, de manière à ce qu'une fonction de transfert pour ladite intégration présente un module vérifiant l'équation suivante :

[Math 1]

$$|G(f)| = \frac{\sqrt{2(1 - \cos(2\pi f T_{int}))}}{\frac{f}{F_{int}}}$$

où G représente le gain et f la fréquence,

$T_{int}$ représente la durée de la fenêtre temporelle W1, W2 ; et

$F_{int}$ vérifie l'équation suivante :

[Math 2]

$$F_{int} = \frac{g_m}{2\pi C_{int}}$$

avec $g_m$ représentant une transconductance de l'intégration, et.

$C_{int}$ représentant une capacité de l'intégration.

L'homme du métier comprendra alors que le module d'intégration 12 est configuré pour obtenir une valeur moyenne du signal d'entrée Xe sur une fenêtre temporelle W1, W2 respective via ladite intégration du signal d'entrée Xe lors de cette fenêtre temporelle W1, W2 respective. En d'autres termes, le module d'intégration 12 forme un moyenneur fenêtré lors de chacune des fenêtres temporelles successives W1, W2.

Le module d'intégration 12 comporte au moins une unité d'intégration 20, chaque unité d'intégration 20 étant connectée en entrée du module de sommation 16 et configurée pour effectuer une intégration du signal d'entrée Xe lors d'au moins une fenêtre temporelle W1, W2.

Le module d'intégration 12 comporte de préférence plusieurs unités d'intégration 20 agencées en parallèle les unes des autres, chacune étant configurée pour effectuer une intégration du signal d'entrée Xe lors d'une fenêtre temporelle W1, W2 respective.

De préférence encore, le nombre d'unités d'intégration 20 est égal au nombre total de fenêtres temporelles successives W1, W2, associées au module d'intégration 12. Dans l'exemple des figures 1 et 2, le module d'intégration 12 comporte alors No+Nb unités d'intégration 20 distinctes et agencées en parallèle les unes des autres.

Cet agencement en parallèle des unités d'intégration 20 permet alors de paralléliser les opérations requises pour effectuer l'intégration du signal d'entrée Xe lors de la pluralité de fenêtres temporelles successives W1, W2 et d'obtenir alors un filtrage plus rapide du signal d'entrée Xe.

En variante, le module d'intégration 12 comporte une unique unité d'intégration 20 pour effectuer l'intégration du signal d'entrée Xe lors de la pluralité de fenêtres temporelles W1, W2 successives.

Le module de génération 14 est configuré pour générer des fronts d'horloge correspondant aux instants temporels initiaux et finaux des fenêtres temporelles W1, W2 successives.

Le module de génération 14 est alors typiquement configuré pour générer des fronts d'horloge correspondant aux instants temporels initiaux des fenêtres temporelles W1, W2 successives, et d'autres fronts d'horloge correspondant aux instants temporels finaux des fenêtres temporelles W1, W2.

Le module de génération 14 comprend par exemple une unité 22 de synthèse de fréquence et une unité 24 de réplication de fronts. L'unité de synthèse de fréquence 22 est également appelée unité PLL (de l'anglais *Phase-Locked Loop*), celle-ci étant configurée pour mettre en oeuvre une boucle à phase asservie, également appelée boucle à verrouillage de phase. Classiquement, l'unité de synthèse de fréquence 22 comporte alors un oscillateur de référence 26 connecté en entrée d'un diviseur de référence 28, lui-même connecté en entrée d'un bloc 30 incluant un comparateur de phase, également noté PFD (de l'anglais *Phase Frequency Detector*) et une pompe de charge. L'unité de synthèse de fréquence 22 comporte également un filtre de boucle 32 connecté en sortie du bloc 30 et un oscillateur en anneau 34 connecté en sortie du filtre de boucle 32, l'oscillateur en anneau 34 comprenant No phases. L'unité de synthèse de fréquence 22 comporte enfin un diviseur de boucle 36 connecté en sortie de l'oscillateur en anneau 34 et formant un rebouclage vers le bloc 30 incluant le comparateur de phase et la pompe de charge, en étant connecté en entrée dudit bloc 30.

L'homme du métier comprendra alors que l'unité de synthèse de fréquence 22 est basé sur la boucle à verrouillage de phase contenant l'oscillateur en anneau 34 avec No phases, la boucle à verrouillage de phase recevant - de la part de l'oscillateur de référence 26 - une fréquence de référence qui est ensuite divisée par le diviseur de référence 28, avant d'être comparée par le comparateur de phase du bloc 30 à une fréquence de base Fb issue de l'oscillateur en anneau 34 et elle-même divisée par le diviseur de boucle 36. La pompe de charge du bloc 30 intègre la différence de phase, et le filtre de boucle 32 connecté entre le bloc 30 et l'oscillateur en anneau 34 sert à stabiliser la boucle et à fournir une consigne en tension à l'oscillateur en anneau 34. Cette consigne en tension permet d'ajuster le délai de cellules de l'oscillateur 34, afin de converger vers la fréquence de base Fb visée.

L'unité de réplication de fronts 24 comporte un ensemble 38 de cellules répliquées de l'oscillateur en anneau pour générer en No+Nb+Na phases et un étage 39 de combinaison de fronts, apte à fournir les fronts d'horloge au module d'intégration 12.

L'homme du métier comprendra alors que l'ensemble 38 comporte No+Nb+Na cellules retard qui sont identiques aux cellules constituant l'oscillateur en anneau 34 de l'unité de synthèse de fréquence 22 et permettent alors de générer les horloges de commande pour le module d'intégration 12. Le nombre Na de phases additionnelles provient du fait qu'un nombre de fronts supérieur au nombre No+Nb de fenêtres temporelles W1, W2 est nécessaire pour construire les fronts des horloges de commande correspondant aux instants temporels finaux des fenêtres temporelles W1, W2.

L'homme du métier observera que la consigne en tension issue du filtre de boucle 32 et fournie à l'oscillateur en anneau 34 est également utilisée en commande de la ligne à retard pour l'ensemble 38 de cellules répliquées, ceci afin de générer toutes les phases d'horloge nécessaires à la génération des horloges pour le module d'intégration 12. L'étage de combinaison 39 est ensuite apte à recevoir les phases d'horloge et à générer en sortie, via une logique combinatoire, tous les fronts d'horloge pour le module d'intégration 12.

L'homme du métier notera alors que la fréquence de base Fb visée, telle que la fréquence de coupure Fc pour le filtre coupe-bande 10, est facilement modifiable avec le module de génération 14, puisqu'il suffit pour cela de modifier un rang de division du diviseur de boucle 36, voire également un rang de division du diviseur de référence 28.

Le module de génération 14 permet alors de reconfigurer facilement la valeur de la fréquence de base Fb utilisée par le module d'intégration 12, telle que la fréquence de coupure Fc pour le filtre coupe-bande 10.

En effet, une modification du rang de division du diviseur de boucle 36, voire de celui du diviseur de référence 28, entraîne un ajustement automatique de la fréquence de l'oscillateur en anneau 34, ainsi que de toutes les phases de la ligne à retard à cellules répliquées, suivies des horloges générées par l'étage de combinaison 39.

Le module de sommation 16 est configuré pour sommer les signaux intermédiaires Si issus du module d'intégration 12 et pour délivrer à sa sortie le signal filtré E, le signal filtré E étant fonction de la somme desdits signaux intermédiaires Si. Le module de sommation 16 est en particulier configuré pour effectuer une sommation non signée des signaux intermédiaires Si, c'est-à-dire une accumulation non signée des signaux intermédiaires Si.

Le module de sommation 16 est un module numérique lorsque les signaux intermédiaires Si issus du module d'intégration 12 sont des signaux numériques, lesdits signaux numériques intermédiaires étant alors notés Di. En variante, le module de sommation 16 est un module analogique lorsque les signaux intermédiaires Si issus du module d'intégration 12 sont des signaux analogiques, lesdits signaux analogiques intermédiaires étant alors notés Ai.

Chaque unité d'intégration 20 comporte par exemple un étage analogique de conversion 40 connecté en entrée d'un étage moyenneur 42. Lorsque l'unité d'intégration 20 est configurée pour délivrer un signal numérique intermédiaire Di, l'unité d'intégration 20 comporte en outre un convertisseur analogique-numérique 44 connecté en sortie de l'étage moyenneur 42.

En complément facultatif, l'étage moyenneur 42 et le convertisseur analogique-numérique 44 sont de préférence réalisés sous forme d'un convertisseur analogique-numérique avec registre à approximations successives 46, également appelé SAR-ADC 46 (de l'anglais *Successive Approximations Register - Analog to Digital Converter*).

Le convertisseur analogique-numérique avec registre à approximations successives 46 comprend typiquement un convertisseur numérique-analogique avec une entrée et une sortie ; un comparateur avec deux entrées et une sortie, une entrée étant connectée à la sortie du convertisseur numérique-analogique et l'autre entrée étant adaptée pour recevoir un signal de référence ; et une unité logique avec registre à approximations successives connectée à la sortie du comparateur, l'unité logique avec registre à approximations successives étant adaptée pour commander le convertisseur numérique-analogique. Le convertisseur numérique-analogique contient aussi un réseau de condensateurs (de l'anglais *capacitor array*), également appelé peigne de condensateurs.

Selon ce complément facultatif, le réseau de condensateurs du convertisseur analogique-numérique avec registre à approximations successives 46 remplit alors une double fonction, à savoir sa fonction habituelle au sein d'un SAR-ADC, c'est-à-dire une fonction de maintien, i.e. une fonction de mémorisation, pendant la phase d'échantillonnage du SAR-ADC 46, et en outre une fonction de moyennage, i.e. une fonction d'intégration, le réseau de condensateurs formant alors l'étage moyenneur 42.

Selon ce complément facultatif, l'homme du métier comprendra alors que l'intégration du signal d'entrée Xe lors de la fenêtre temporelle W1, W2 respective est réalisée conjointement avec la conversion analogique-numérique, ce qui permet alors de proposer un filtre coupe-bande 10 encore plus compact et avec une latence encore plus réduite.

L'étage analogique de conversion 40 est configuré pour effectuer, lors de la fenêtre temporelle W1, W2 respective, une conversion de tension en courant, et est par exemple en forme d'une cellule de transimpédance.

L'étage moyenneur 42 est configuré pour effectuer, lors de la fenêtre temporelle W1, W2 respective, une moyenne du signal issu de l'étage de conversion 40, et comporte typiquement un ensemble de condensateurs agencés en parallèle et connectés entre la sortie de l'étage de conversion 40 et une masse électrique 48.

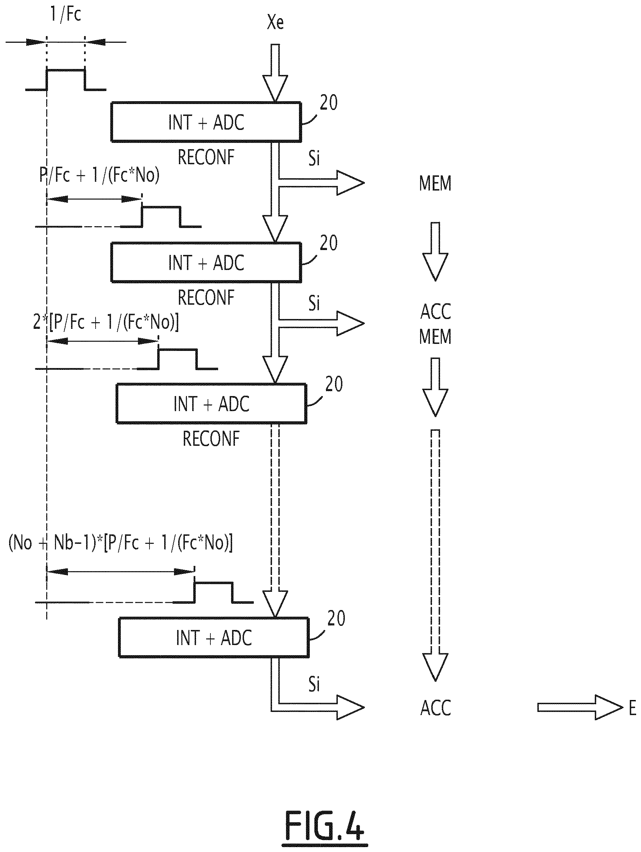

Lorsque le module d'intégration 12 comporte en variante une unique unité d'intégration 20, le module d'intégration 12 est alors configuré pour commander les instants temporels initiaux respectifs pour les fenêtres temporelles W1, W2 successives, avec un décalage temporel suffisant d'un instant temporel initial à l'autre pour permettre l'intégration du signal d'entrée Xe lors de chaque fenêtre temporelle W1, W2 respective avec ladite unique unité d'intégration 20, et pour permettre également sa reconfiguration avant de passer à la fenêtre temporelle suivante, comme illustré sur l'organigramme de la figure 4.

Dans l'exemple de la figure 4, les No+Nb intégrations associées au No+Nb fenêtres temporelles W1, W2 successives sont réalisées avec la même unité d'intégration 20 et de manière sérialisée, le décalage entre deux instants temporels initiaux successifs étant égal à P/Fc + 1/(Fc*No), avec P/Fc représentant un nombre P de périodes égales à l'inverse de la fréquence de coupure Fc et 1/(Fc*No) représentant une largeur de glissement, dans le cas où des glissements entre fenêtres temporelles successives, par exemple entre les No premières fenêtres temporelles W1, sont régulièrement répartis et correspondent alors à des décalages de phase séparés de 360°/No.

**[0076]** À l'issue de chaque intégration du signal d'entrée Xe au cours d'une fenêtre temporelle W1, W2 respective, le module d'intégration 12 est alors apte à effectuer une reconfiguration, notée RECONF, de l'unité d'intégration 12 avant la prochaine intégration avec la fenêtre temporelle suivante, et le module de sommation 16 est configuré pour effectuer une accumulation, notée ACC, du signal intermédiaire Si obtenu pour l'intégration du signal d'entrée Xe lors de la fenêtre temporelle courante avec les précédents signaux intermédiaires Si déjà obtenus et ayant fait l'objet d'une mémorisation, notée MEM.

Autrement dit, à l'issue de chaque intégration fenêtrée effectuée par l'unité d'intégration 20, le module de sommation 16 effectue l'accumulation ACC du signal intermédiaire Si ainsi obtenu avec les signaux intermédiaires Si précédemment obtenus, puis la mémorisation MEM afin que le résultat de l'accumulation ACC courante puisse ensuite être accumulé avec le signal intermédiaire Si qui sera obtenu à l'issue de la prochaine intégration fenêtrée, et ainsi de suite.

À l'issue de la dernière intégration fenêtrée effectuée par l'unité d'intégration 20, le module de sommation 16 effectue une dernière accumulation ACC du dernier signal intermédiaire Si obtenu et de la mémorisation MEM précédemment effectuée et correspondant à la somme des No+Nb-1 signaux intermédiaires Si précédemment obtenus, ceci pour délivrer le signal filtré E en sortie du filtre coupe-bande 10.

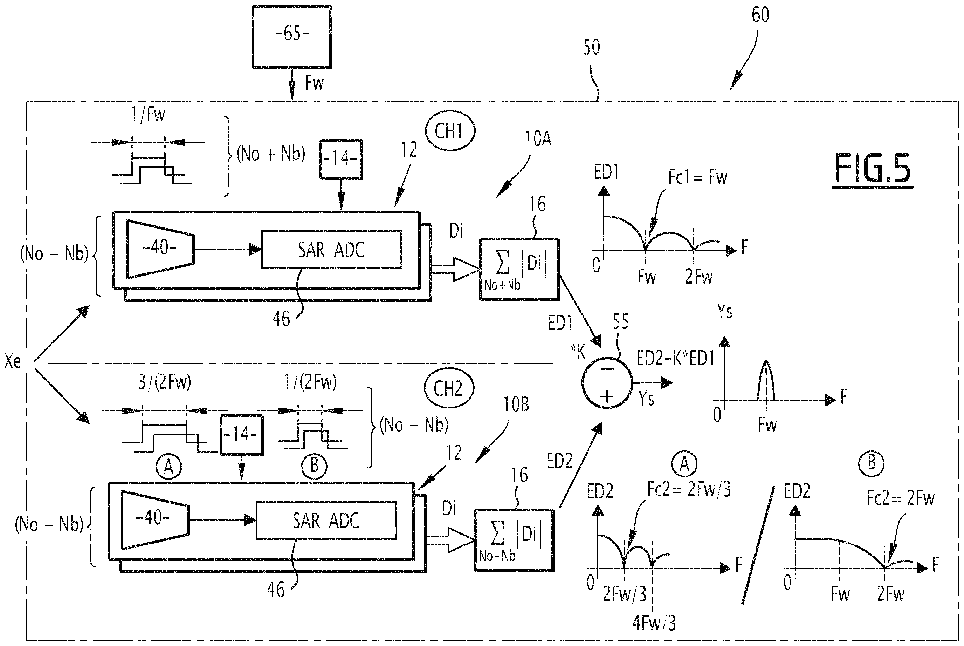

Sur la figure 5, un dispositif électronique de filtrage passe-bande 50 est configuré pour recevoir le signal d'entrée Xe et délivrer un signal de sortie Ys présentant, en dehors d'une bande de fréquences centrée autour d'une fréquence cible Fw, également appelée fréquence de travail, une amplitude atténuée par rapport à celle du signal d'entrée Xe. En d'autres termes, le dispositif de filtrage passe-bande 50 est apte à conserver sensiblement seulement ladite bande fréquences du signal d'entrée Xe pour délivrer le signal de sortie Ys.

Selon l'invention, le dispositif de filtrage passe-bande 50 comprend au moins un filtre coupe-bande 10 tel que défini ci-dessus.

Dans l'exemple de la figure 5, le dispositif de filtrage passe-bande 50 comprend un premier filtre coupe-bande 10A, apte à recevoir le signal d'entrée Xe et à délivrer un premier signal filtré E1 présentant, en une première fréquence de coupure Fc1, une amplitude atténuée par rapport à celle du signal d'entrée Xe, la première fréquence de coupure Fc1 étant sensiblement égale à la fréquence cible Fw.

Selon cet exemple de la figure 5, le dispositif de filtrage passe-bande 50 comprend un deuxième filtre coupe-bande 10B, apte à recevoir le signal d'entrée Xe et à délivrer un deuxième signal filtré E2 présentant, en une deuxième fréquence de coupure Fc2, une amplitude atténuée par rapport à celle du signal d'entrée Xe, la deuxième fréquence de coupure Fc2 étant distincte de la première fréquence de coupure Fc1, la deuxième fréquence de coupure Fc2 étant strictement inférieure à la fréquence cible Fw ou bien strictement supérieure à ladite fréquence cible Fw.

Dans la suite de la description, par convention, le premier signal filtré E1 est également noté ED1 lorsque ledit premier signal filtré est numérique, ou encore EA1 lorsque ledit premier signal filtré est analogique. De manière analogue, le deuxième signal filtré E2 est également noté ED2 lorsque ledit deuxième signal filtré est numérique, ou encore EA2 lorsque ledit deuxième signal filtré est analogique.

Selon l'invention, au moins l'un, et de préférence chacun, des premier 10A et deuxième 10B filtres coupe-bande est un filtre coupe-bande 10 tel que défini ci-dessus.

Dans l'exemple de la figure 2, les premier 10A et deuxième 10B filtres coupe-bande sont chacun un filtre coupe-bande 10 tel que défini ci-dessus, et ne sont alors pas à nouveau décrits en détail.

Le dispositif de filtrage passe-bande 50 comprend également un module de génération 55 connecté en sortie des premier 10A et deuxième 10B filtres coupe-bande et configuré pour générer le signal de sortie Ys à partir d'une combinaison des premier E1 et deuxième E2 signaux filtrés.

L'homme du métier observera alors que chaque filtre coupe-bande 10A, 10B comporte typiquement le module d'intégration 12, le module de génération 14 et le module de sommation 16, et que la seule différence entre les premier 10A et deuxième 10B filtres coupe-bande réside dans la valeur différente de la fréquence de coupure Fc mise en oeuvre, à savoir la première fréquence de coupure Fc1 pour le premier filtre coupe-bande 10A, et la deuxième fréquence de coupure Fc2 pour le deuxième filtre coupe-bande 10B.

Dans l'exemple de la figure 5, chaque filtre coupe-bande 10A, 10B a son propre module de génération 14, ceci afin de générer séparément les fronts d'horloge pour les fenêtres temporelles successives associées à la première fréquence de coupure Fc1, de ceux pour les fenêtres temporelles successives associées à la deuxième fréquence de coupure Fc2. En variante, les premier 10A et deuxième 10B filtres coupe-bande ont un même module de génération 14 en commun, celui-ci étant alors configuré pour générer les fronts d'horloge à la fois pour les fenêtres temporelles associées à la première fréquence de coupure Fc1 et pour celles associées à la deuxième fréquence de coupure Fc2.

L'homme du métier comprendra qu'étant donné que la première fréquence de coupure Fc1 est sensiblement égale à la fréquence cible Fw, le premier filtre coupe-bande 10A forme alors un filtre coupe-bande, ou encore un filtre stop-bande autour de la fréquence cible Fw. Le deuxième filtre coupe-bande 10B forme un filtre passe-bande autour de la fréquence cible Fw lorsque la deuxième fréquence de coupure Fc2 est strictement inférieure à la fréquence cible Fw, et de préférence lorsque celle-ci est sensiblement égale à 2/3 de la fréquence cible Fw, ou encore à 2/5 de ladite fréquence cible Fw. En variante, le deuxième filtre coupe-bande 10B forme un filtre passe-bas autour de la fréquence cible Fw lorsque la deuxième fréquence de coupure Fc2 est strictement supérieure à la fréquence cible Fw, et de préférence sensiblement égale à deux fois la fréquence cible Fw.

La combinaison, obtenue via le module de génération 55, d'un tel filtre passe-bande autour de la fréquence cible Fw et d'un filtre coupe-bande autour de cette fréquence cible Fw, ou en variante la combinaison d'un filtre passe-bas autour de la fréquence cible Fw et du filtre coupe-bande autour de la fréquence cible Fw, permet alors d'obtenir un filtre passe-bande résultant qui offre une sélectivité plus élevée et une meilleure réjection autour de la fréquence cible Fw.

Ainsi, le dispositif de filtrage passe-bande 50 selon l'invention permet d'offrir une bonne sélectivité et une forte réjection autour de la fréquence cible Fw, ceci même si le filtrage coupe-bande effectué à la première fréquence de coupure Fc1 et/ou celui effectué à la deuxième fréquence de coupure Fc2 sont en eux-mêmes peu sélectifs autour de la fréquence de coupure Fc1, Fc2 respective.

L'homme du métier notera que, dans les exemples des figures 5 à 16, le filtrage coupe-bande à la première fréquence de coupure Fc1, également appelé premier filtrage coupe-bande, correspond à un premier canal CH1 ; et que le filtrage coupe-bande en la deuxième fréquence de coupure Fc2, également appelé deuxième filtrage coupe-bande, correspond à un deuxième canal CH2. Le deuxième canal CH2 est en outre noté dans une configuration A lorsque le deuxième filtrage coupe-bande forme un filtrage passe-bande autour de la fréquence cible Fw, c'est-à-dire lorsque la deuxième fréquence de coupure Fc2 est strictement inférieure à la fréquence cible Fw ; et noté dans une configuration B lorsque le deuxième filtrage coupe-bande forme un filtrage passe-bas autour de la fréquence cible Fw, c'est-à-dire lorsque la deuxième fréquence de coupure Fc2 est strictement supérieure à la fréquence cible Fw.

En variante de réalisation, le dispositif électronique de filtrage passe-bande 50 comprend un unique filtre coupe-bande 10 tel que défini ci-dessus, et comprend alors en outre un module de commande configuré pour commander cet unique filtre coupe-bande 10, d'une part avec la fréquence de coupure égale à la première fréquence de coupure Fc1 ceci pour réaliser le filtrage coupe-bande autour de la fréquence cible Fw pour le premier canal CH1, et d'autre part avec la deuxième fréquence de coupure Fc2 pour réaliser le filtrage passe-bande autour de la fréquence cible Fw selon la configuration A, ou encore le filtrage passe-bas autour de la fréquence cible Fw selon la configuration B pour le deuxième canal CH2.

Le module de commande est alors par exemple configuré pour commander le filtre coupe-bande 10 avec sa fréquence de coupure égale à l'une parmi la première fréquence de coupure Fc1 et la deuxième fréquence de coupure Fc2, et mémoriser le signal obtenu parmi le premier signal filtré E1 et le deuxième signal filtré E2. Le module de commande est configuré pour commander ensuite le filtre coupe-bande 10 avec sa fréquence de coupure égale à l'autre parmi la première fréquence de coupure Fc1 et la deuxième fréquence de coupure Fc2, afin d'obtenir l'autre signal parmi le premier signal filtré E1 et le deuxième signal filtré E2.

Selon cette variante de réalisation, le dispositif de filtrage passe-bande 50 comprend également le module de génération 55 configuré pour générer le signal de sortie Ys à partir d'une combinaison des premier E1 et deuxième E2 signaux filtrés, le module de génération 50 étant alors connecté en sortie du module de commande.

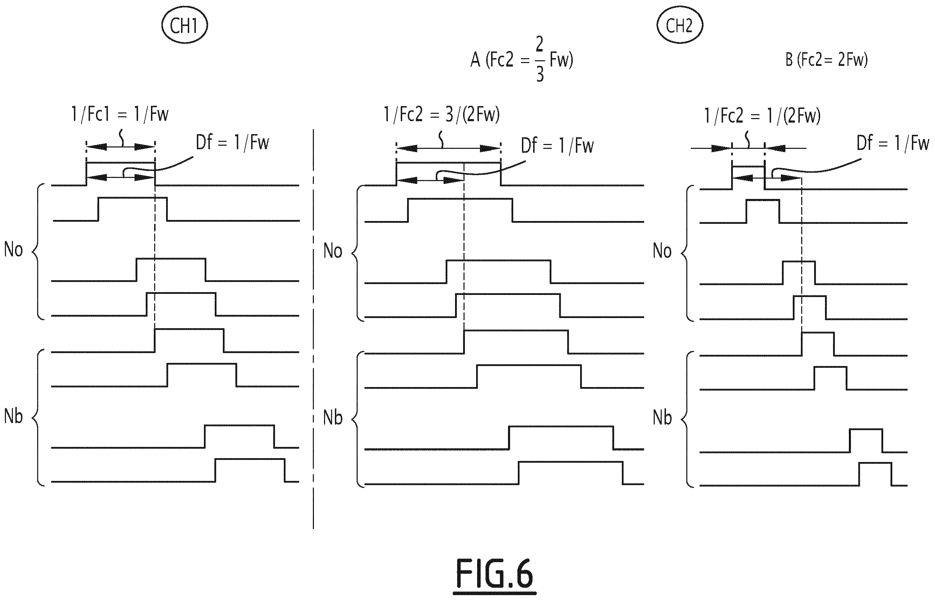

L'homme du métier relèvera que, quelle que soit la variante de réalisation du dispositif de filtrage passe-bande 50 selon l'invention, lorsque le premier filtrage coupe-bande et le deuxième filtrage coupe-bande sont chacun effectués à l'aide d'un filtre coupe-bande 10 tel que défini ci-dessus, alors les premier et deuxième filtrages coupe-bande sont obtenus via des intégrations fenêtrées pour plusieurs fenêtres temporelles successives pour chacun desdits filtrages, typiquement pour No+Nb fenêtres temporelles successives pour le premier filtrage sur le premier canal CH1 d'une part, et pour No+Nb fenêtres temporelles successives pour le deuxième filtrage sur le deuxième canal CH2 d'autre part, comme représenté à la figure 6.

L'homme du métier observera alors que la différence entre les intégrations fenêtrées effectuées pour le premier filtrage coupe-bande du premier canal CH1 et celles effectuées pour le deuxième filtrage coupe-bande du deuxième canal CH2 réside dans la durée des fenêtres temporelles respectives. En effet, pour le filtrage coupe-bande via des intégrations fenêtrées, la durée de chaque fenêtre temporelle est sensiblement égale à l'inverse de la fréquence de coupure Fc visée, et étant donné que la première fréquence de coupure Fc1 est distincte de la deuxième fréquence de coupure Fc2, les fenêtres temporelles utilisées pour le premier canal CH1 d'une part et pour le deuxième canal CH2 d'autre part, présentent alors des durées distinctes.

En complément, étant donné qu'un filtre coupe-bande est destiné à engendrer des atténuations du signal filtré pour des multiples de sa fréquence de coupure, la deuxième fréquence de coupure Fc2 est de préférence choisie de manière à ce que la fréquence cible Fw soit approximativement au milieu de deux multiples de ladite deuxième fréquence de coupure Fc2.

Selon ce complément, la fréquence cible Fw vérifie par exemple l'équation suivante :

[Math 3]

$$Fw = \frac{L \cdot Fc2 + (L + 1) \cdot Fc2}{2}$$

où Fw représente la fréquence cible,
Fc2 représente la deuxième fréquence de coupure, et
L est un nombre entier positif.

La deuxième fréquence de coupure Fc2 est alors de préférence un multiple rationnel de la fréquence cible Fw. La deuxième fréquence de coupure Fc2 vérifie par exemple l'équation suivante :

[Math 4]

$$Fc2 = \frac{2 \cdot Fw}{2 \cdot L + 1}$$

où Fc2 représente la deuxième fréquence de coupure,
Fw représente la fréquence cible, et
L est un nombre entier positif.

L'équation (4) permet alors de retrouver les exemples précités de valeurs de la deuxième fréquence de coupure Fc2. En particulier, pour L = 0, la deuxième fréquence de coupure Fc2 est sensiblement égale à deux fois la fréquence cible Fw ; pour L = 1, la deuxième fréquence de coupure Fc2 est sensiblement égale à 2/3 de la fréquence cible Fw ; et pour L = 2, la deuxième fréquence de coupure Fc2 est sensiblement égale à 2/5 de la fréquence cible Fw ; et ainsi de suite.

Dans l'exemple de la figure 6, la durée prédéfinie de référence Df est égale à l'inverse de la fréquence cible Fw, et pour chaque pluralité de fenêtres temporelles successives associées à un filtrage coupe-bande respectif, les instants temporels initiaux d'au moins deux fenêtres distinctes sont alors séparés d'un décalage temporel de valeur supérieure ou égale à cette durée prédéfinie de référence Df, et donc à l'inverse de la fréquence cible Fw.

L'homme du métier comprendra alors que, dans cet exemple de la figure 6, la durée prédéfinie de référence Df est choisie en fonction de la première fréquence de coupure Fc1, et alors égale à l'inverse de la première fréquence de coupure Fc1, i.e. égale à l'inverse de la fréquence cible Fw.

Cette durée prédéfinie de référence Df est alors de préférence utilisée à la fois pour le premier filtrage coupe-bande du premier canal CH1 et pour le deuxième filtrage coupe-bande du deuxième canal CH2. Ceci autorise alors typiquement une synchronisation des instants temporels initiaux des fenêtres temporelles successives mises en oeuvre pour le deuxième filtrage coupe-bande du deuxième canal CH2 avec ceux des fenêtres temporelles successives mises en oeuvre pour le premier filtrage coupe-bande du premier canal CH1. Une telle synchronisation permet alors d'obtenir plus simplement une information de phase, ainsi que décrit par la suite en regard de la figure 2, tout en autorisant également une implémentation plus simple du dispositif de filtrage passe-bande 50.

Le module de génération 55 est configuré pour générer le signal de sortie Ys à partir d'une combinaison des premier E1 et deuxième E2 signaux filtrés. Le module de génération 55 est alors par exemple configuré pour effectuer une combinaison linéaire des premier E1 et deuxième E2 signaux filtrés pour obtenir le signal de sortie Ys.

La combinaison linéaire des premier E1 et deuxième E2 signaux filtrés vérifie par exemple l'équation suivante :

[Math 5]

$$Ys = E2 - K \cdot E1$$

où Ys représente le signal de sortie,
E1 représente le premier signal filtré,
E2 représente le deuxième signal filtré,
K est un nombre entier supérieur ou égal à 1.

Le multiple K est typiquement une puissance de 2, et s'écrit alors :

[Math 6]

$$K = 2^P$$

avec P entier positif.

Le dispositif électronique de filtrage passe-bande 50 selon l'invention est en outre apte à être implémenté selon différentes implémentations.

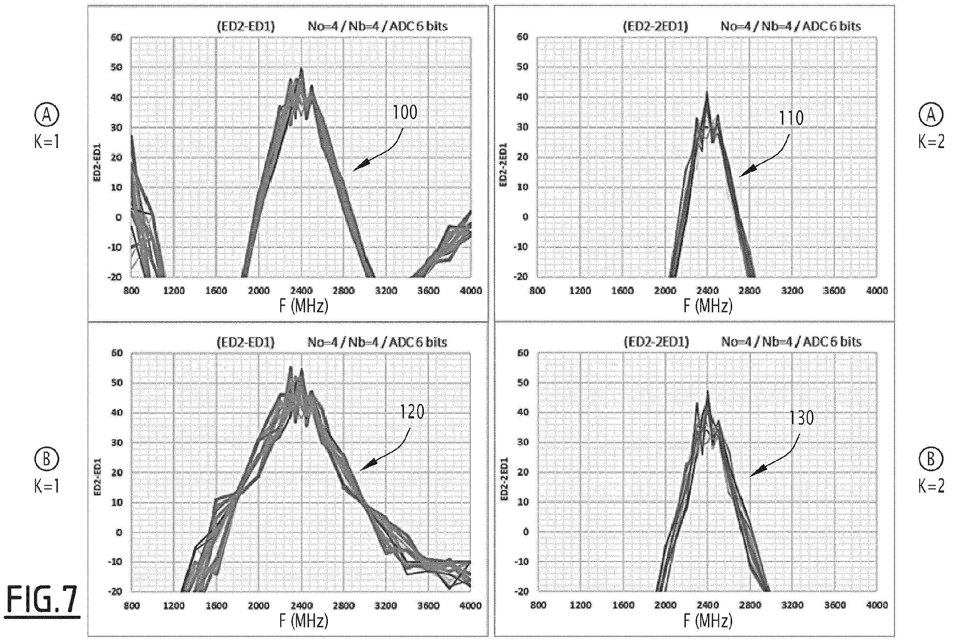

Dans l'exemple de la figure 5, l'implémentation du dispositif de filtrage passe-bande 50 est une implémentation essentiellement numérique, seul l'étage de conversion 40 étant un étage analogique, et les éléments connectés à la suite de cet étage de conversion 40 étant, sur chaque canal CH1, CH2, des éléments numériques avec successivement, le convertisseur analogique-numérique avec registre à approximations successives 46, le module de sommation 16 de type numérique et le module de génération 55 également de type numérique. Les figures 7 à 12 illustrent alors des résultats de simulations numériques effectuées avec l'implémentation de la figure 5, et seront décrits plus en détail ci-après.

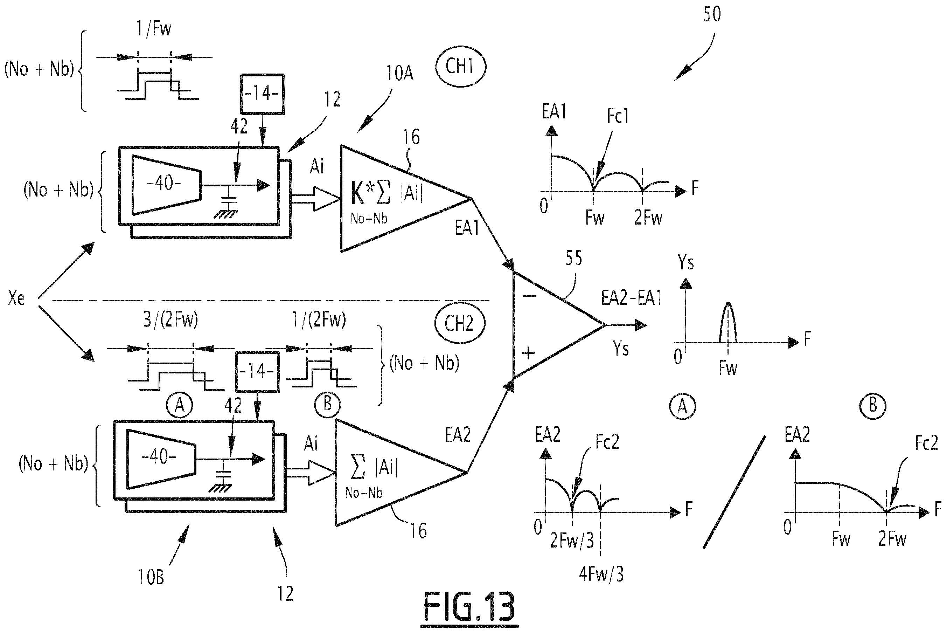

Dans l'exemple de la figure 13, l'implémentation du dispositif de filtrage passe-bande 50 est complètement analogique, l'étage de conversion 40 et l'étage moyenneur 42 de chaque unité d'intégration 20 étant des étages analogiques, connectés en entrée du module de sommation 16 également de type analogique, et les deux modules analogiques de sommation 16 des deux canaux CH1, CH2 sont eux-mêmes connectés en entrée d'un module de génération 55 de type analogique, celui-ci étant par exemple un amplificateur opérationnel, agencé en montage soustracteur.

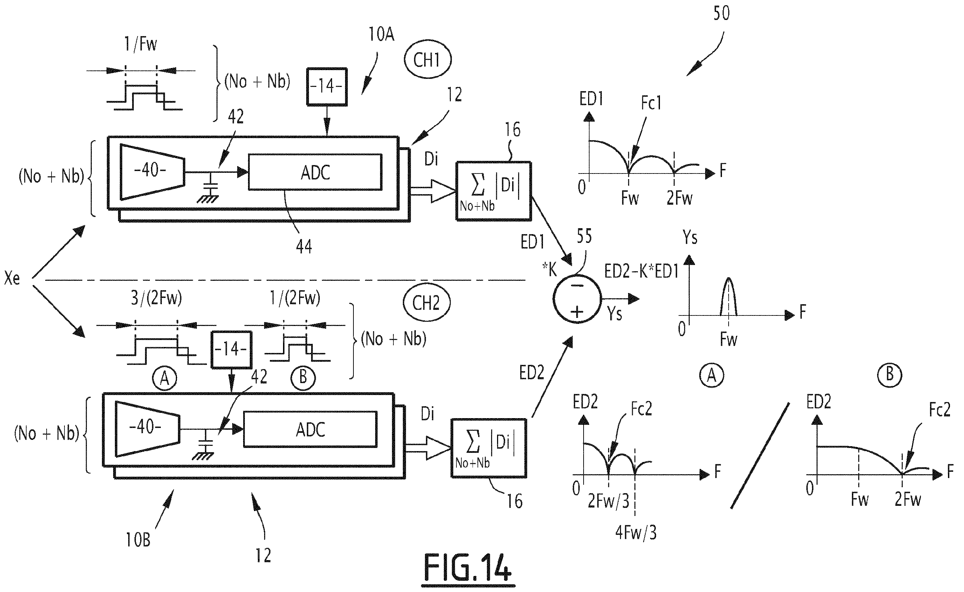

Dans l'exemple de la figure 14, l'implémentation du dispositif de filtrage passe-bande 50 est partiellement analogique et partiellement numérique, les étages de conversion 40 et le moyenneur 42 étant analogiques et connectés en entrée du convertisseur analogique-numérique 44 au sein de chaque unité d'intégration 20, et chaque convertisseur analogique-numérique 44 est alors connecté en entrée d'un module de sommation 16 respectif de type numérique, chaque module de sommation 16 étant lui-même connecté en entrée d'un module de génération 55 de type numérique.

Une application importante du dispositif de filtrage passe-bande 50 selon l'invention est la détection de fréquence, et un système de détection de fréquence 60, notamment pour récepteur radio, est alors représenté à la figure 5 étant observé que ce système de détection de fréquence 60 est réalisable quelle que soit l'implémentation du dispositif de filtrage passe-bande 50, notamment parmi les exemples d'implémentation des figures 5, 13 et 14.

Le système de détection de fréquence 60 comprend alors le dispositif électronique de filtrage passe-bande 50 apte à recevoir le signal d'entrée Xe et à délivrer le signal de sortie Ys présentant, en dehors de la bande de fréquences centrée autour de la fréquence cible Fw, une amplitude atténuée par rapport à celle du signal d'entrée Xe.

Le système de détection de fréquence 60 comprend en outre un dispositif électronique de pilotage 65 apte à faire varier la valeur de la fréquence cible Fw du dispositif de filtrage passe-bande 50 jusqu'à détection d'une fréquence caractéristique du signal d'entrée Xe, la fréquence caractéristique correspondant alors à la valeur courante de la fréquence cible Fw.

Le dispositif électronique de pilotage 65 est par exemple configuré pour faire varier la valeur de ladite fréquence cible Fw depuis une valeur minimale de la fréquence cible Fw_min jusqu'à une valeur maximale de la fréquence cible Fw_max, avec typiquement une variation d'un pas prédéfini de fréquence entre deux valeurs successives de ladite fréquence cible Fw.

Les figures 7 à 12 illustrent les résultats des simulations effectuées avec le dispositif de filtrage 50 selon l'exemple d'implémentation de la figure 5, et ces résultats sont particulièrement probants, ainsi que cela va être expliqué à présent.

Sur la figure 7, des courbes 100 représentent le signal de sortie Ys obtenu avec la configuration A du deuxième canal CH2 et pour le multiple K égal à 1, les courbes 110 montrant le même signal de sortie Ys toujours pour la configuration A du deuxième canal CH2, et cette fois pour le multiple K égal à 2. Les courbes 120 sont des courbes, analogues aux courbes 100, obtenues pour la configuration B du deuxième canal CH2 et pour le multiple K égal à 1, et les courbes 130 représentent le signal de sortie Ys obtenu avec la configuration B du deuxième canal CH2 et pour le multiple K égal à 2. On observe alors que le dispositif de filtrage passe-bande 50 offre une sélectivité meilleure pour le multiple K égal à 2 que lorsqu'il est égal à 1. Les résultats obtenus sont globalement équivalents avec la configuration A ou la configuration B du deuxième canal CH2, la sélectivité du dispositif de filtrage passe-bande 50 étant toutefois un peu meilleure avec la configuration A qu'avec la configuration B du deuxième canal CH2.

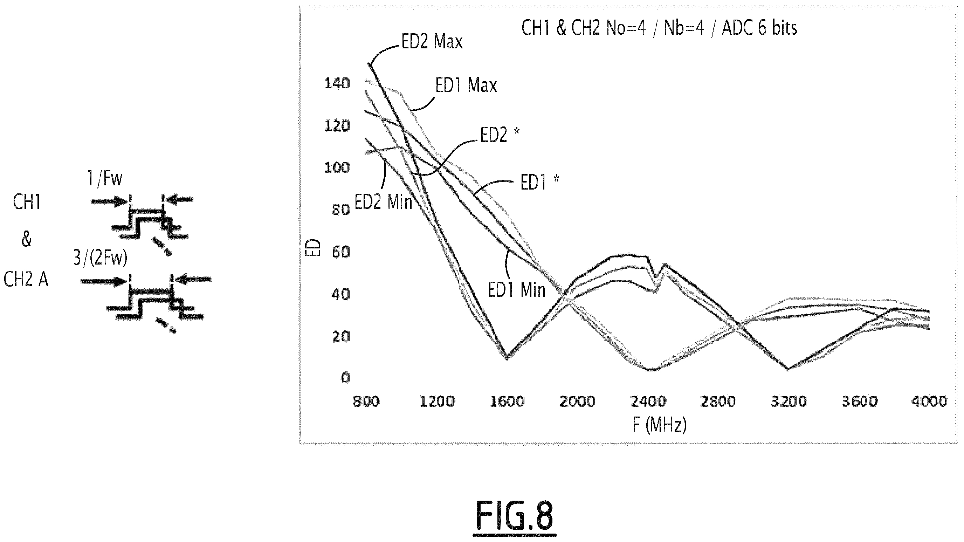

La figure 8 montre ensuite les fonctions de transfert en sortie des premier et deuxième canaux CH1, CH2 et avant la combinaison effectuée par le module de génération 55, ceci pour la configuration A du deuxième canal CH2. On voit alors sur ces résultats que les fonctions de transfert moyennes notées respectivement ED1*, ED2* sont bien représentatives du filtrage effectué, et que la variation de ces fonctions de transfert est relativement faible entre les fonctions de transfert extrêmes, à savoir ED1min et ED1max d'une part, et ED2min et ED2max d'autre part.

Les courbes de la figure 8 montrent en outre que la première fréquence de coupure Fc1, correspondant également à la fréquence cible Fw, est sensiblement égale à 2400 MHz, et que la deuxième fréquence de coupure Fc2 est sensiblement égale 1600 MHz, la deuxième fréquence de coupure Fc2 étant alors bien sensiblement égale à 2/3 de la fréquence cible Fw, s'agissant de la configuration A.

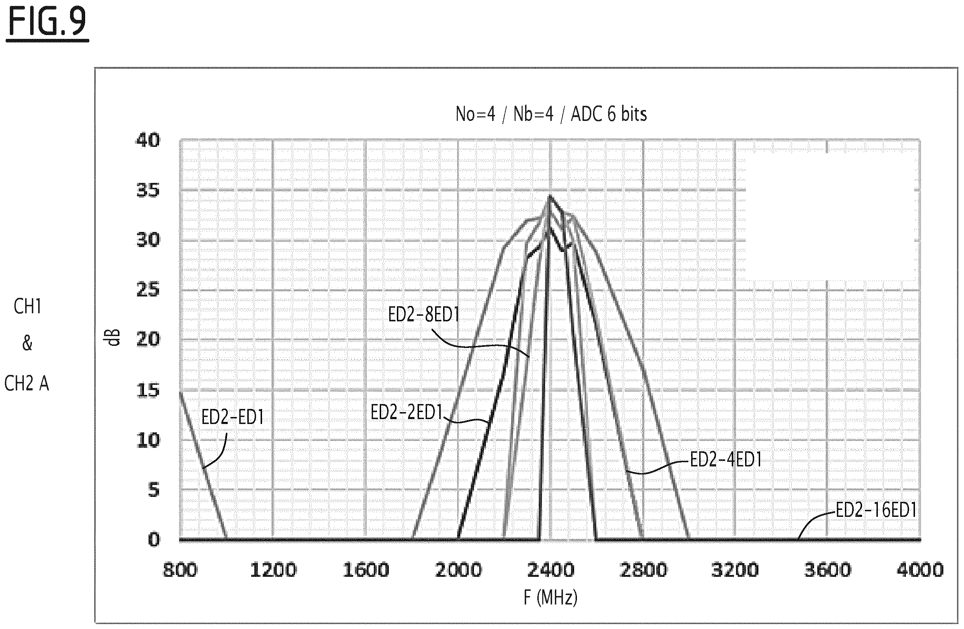

La figure 9 montre les fonctions de transfert obtenues en sortie du dispositif de filtrage passe-bande 50 pour la configuration A du deuxième canal CH2, et pour différentes valeurs du multiple K. Ces courbes confirment que la fréquence cible Fw est sensiblement égale à 2400 MHz, et montrent surtout que plus la valeur du multiple K est élevée, meilleure est la sélectivité du dispositif de filtrage passe-bande 50.

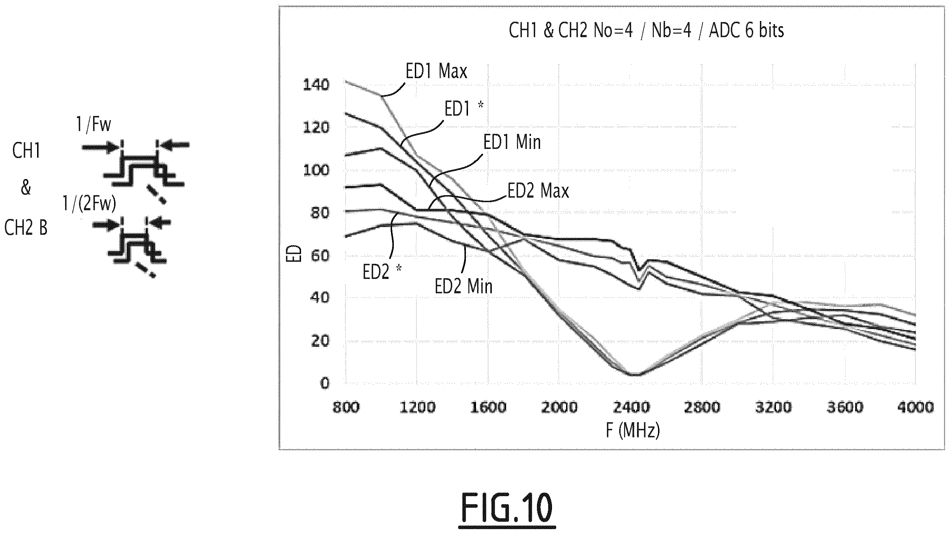

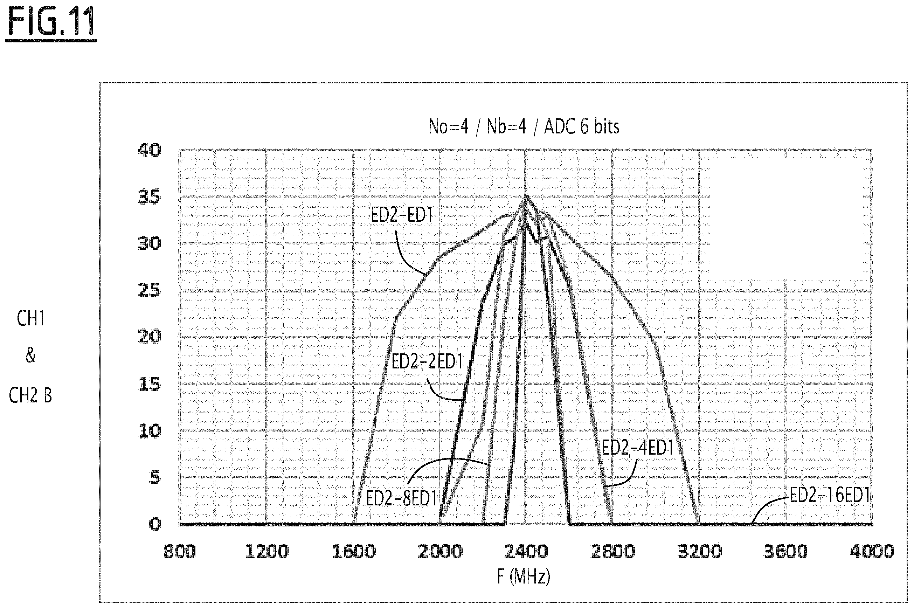

La figure 10 est une vue analogue à celle de la figure 8 pour la configuration B du canal CH2, et la figure 11 est une vue analogue à celle de la figure 9 pour cette configuration B du deuxième canal CH2. Les courbes de la fonction de transfert en sortie du premier canal CH1 visibles sur la figure 10 sont alors identiques à celles visibles sur la figure 8 pour le même premier canal CH1. Les courbes de la fonction de transfert obtenues en sortie du deuxième canal CH2 avec la configuration B, c'est-à-dire avec un filtrage de type passe-bas autour de la fréquence cible Fw sensiblement égale à 2400MHz et avec une deuxième fréquence de coupure Fc2 sensiblement égale à 2Fw, i.e. proche de 4800 MHz, montrent également une faible variabilité, les variations entre les courbes extrêmes ED2min et ED2max de la fonction de transfert, de part et d'autre de la courbe moyenne ED2* de la fonction de transfert, étant en effet assez limitées.

De manière analogue à la figure 9, les courbes visibles à la figure 11 de la fonction de transfert en sortie du dispositif de filtrage passe-bande 50 avec le deuxième canal CH2 en configuration B, montrent que la fréquence cible Fw est aussi sensiblement égale à 2400MHz, avec également une sélectivité meilleure pour les valeurs plus élevées du multiple K.

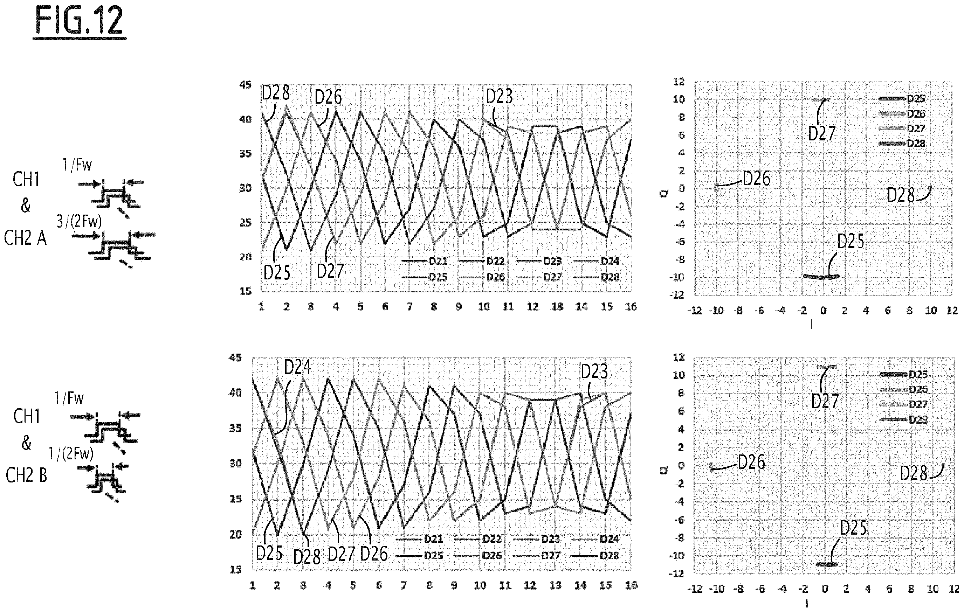

Enfin, les courbes de phases et les diagrammes de constellation représentés à la figure 12 montrent que le dispositif de filtrage passe-bande 50 selon l'invention permet également d'obtenir une information de phase en utilisant des données de conversion issues du deuxième canal CH2, et ce quelle que soit la configuration parmi la configuration A ou B dudit canal CH2.

Ces courbes de la figure 12 montrent en particulier la récupération de 2 fois 4 phases du signal détecté avec les courbes D21 à D28 correspondant aux No+Nb horloges glissantes, avec No = Nb = 4, soit des décalages respectivement égaux à 0°, 90°, 180°, 270°, 360°, 450°, 540° et 630°. Ces courbes et diagrammes de constellation montrent alors que les phases à la fréquence cible Fw sont récupérables à l'issue du processus de filtrage avec une précision intéressante permettant d'envisager des modulations de codage de type PSK (de l'anglais *Phase-Shift Keying*).

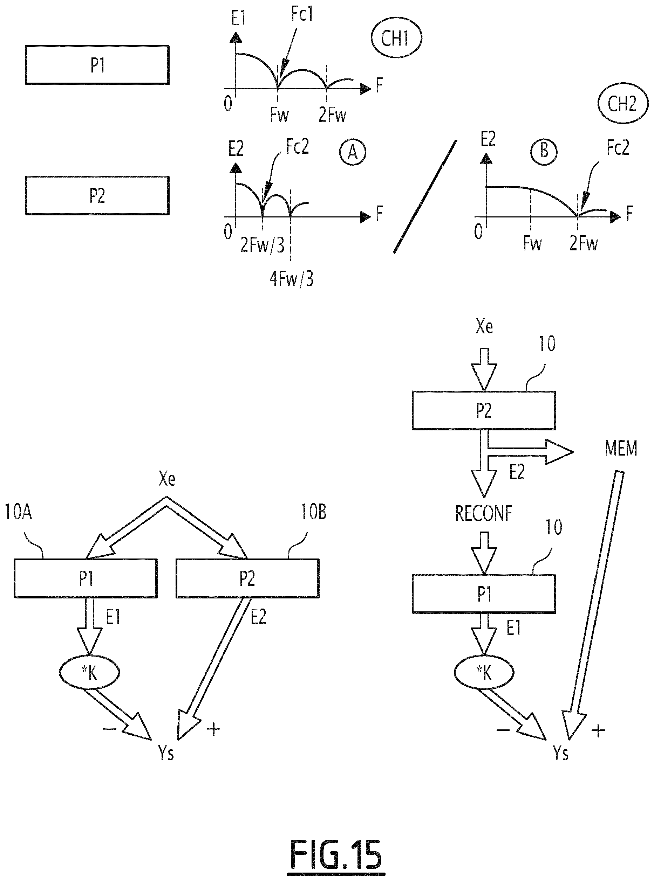

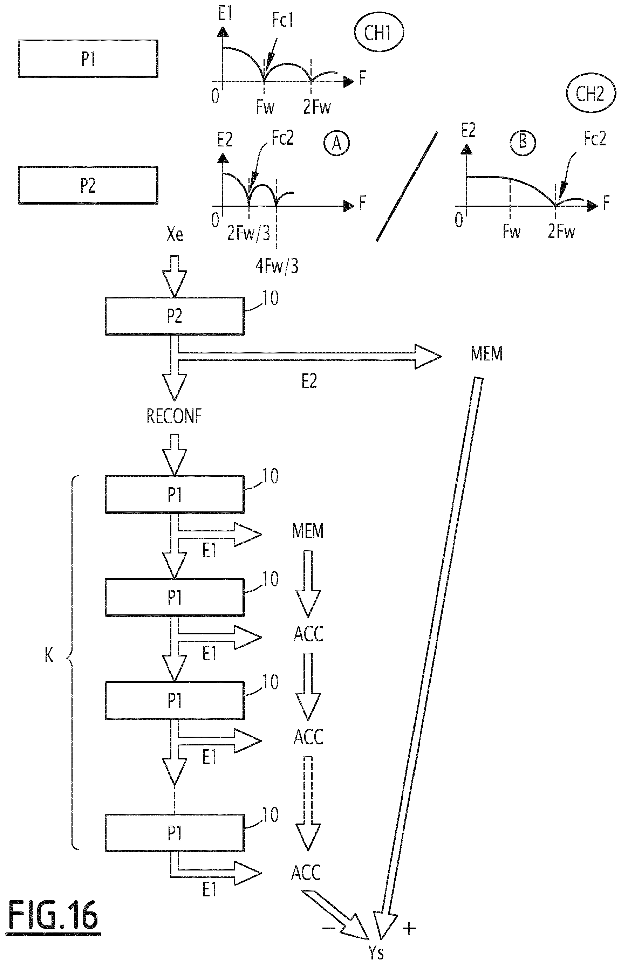

Les figures 15 et 16 illustrent alors différentes variantes de mise en oeuvre du dispositif électronique de filtrage de passe-bande 50 selon l'invention, notamment suivant que le dispositif électronique de filtrage de passe-bande 50 comprend des premier 10A et deuxième 10B filtres coupe-bande distincts et connectés en parallèle l'un de l'autre, ou bien un unique filtre coupe-bande 10 commandé successivement par le module de commande pour effectuer les premier et deuxième filtrages coupe-bande successifs.

Sur les figures 15 et 16, la mise en oeuvre du premier filtrage coupe-bande pour le premier canal CH1 et à la première fréquence de coupure Fc1 correspond à un premier processus P1. La mise en oeuvre du deuxième filtrage coupe-bande pour le deuxième canal CH2 et à la deuxième fréquence de coupure Fc2 correspond à un deuxième processus P2, aussi bien pour la deuxième fréquence de coupure Fc2 sensiblement égale à 2/3 de la fréquence cible Fw et correspondant à la configuration A, que pour la deuxième fréquence de coupure Fc2 sensiblement égale à deux fois la fréquence cible Fw et correspondant à la configuration B.

Une première variante de mise en oeuvre du dispositif de filtrage passe-bande 50, représentée sur la gauche de la figure 15, correspond alors à une mise en oeuvre en parallèle des premier P1 et deuxième P2 processus à partir du signal d'entrée Xe, ceci via le premier filtre coupe-bande 10A pour la premier processus P1 d'une part, et via le deuxième filtre coupe-bande 10B pour le deuxième processus P2 d'autre part. Le résultat issu du premier processus P1 est alors multiplié par le multiple K avant d'être soustrait à celui issu du deuxième processus P2 pour obtenir le signal de sortie Ys.

Une deuxième variante de mise en oeuvre du dispositif de filtrage passe-bande 50, représentée sur la droite de la figure 15, correspond à une mise en oeuvre successive des premier P1 et deuxième P2 processus, typiquement via un unique filtre coupe-bande 10. Selon cette deuxième variante de mise en oeuvre, le signal d'entrée Xe est d'abord traité suivant le deuxième processus P2 à l'issue duquel le deuxième signal filtré E2 obtenu est mémorisé via l'opération de mémorisation MEM. Le filtre coupe-bande 10 est ensuite reconfiguré via l'opération de reconfiguration RECONF afin de pouvoir effectuer le premier processus P1 sur le signal d'entrée Xe, le premier signal filtré E1 obtenu à l'issue de ce premier processus P1 étant alors multiplié par le multiple K, avant d'être soustrait au deuxième signal filtré E2 préalablement mémorisé pour obtenir le signal de sortie Ys.

Une troisième variante de mise en oeuvre du dispositif de filtrage passe-bande 50 selon l'invention est représentée sur la figure 16 et correspond, de la même manière que la deuxième variante, à une sérialisation des premier et deuxième processus P1, P2.

Selon cette troisième variante de mise en oeuvre, le signal d'entrée Xe est d'abord traité par le deuxième processus P2 afin d'obtenir le deuxième signal filtré E2 qui est mémorisé via l'opération de mémorisation MEM. À l'issue du deuxième processus P2, le filtre coupe-bande 10 ayant servi à effectuer ce deuxième processus P2 est reconfiguré via l'opération de reconfiguration RECONF pour pouvoir effectuer le premier processus P1. À la différence de la deuxième variante où le processus P1 est effectué une seule fois avant que le premier signal filtré E1 soit transmis à un multiplicateur pour la multiplication par le multiple K, la troisième variante de réalisation comporte K fois la mise en oeuvre de ce premier processus P1 avec une opération de mémorisation MEM à la fin de la première exécution du premier processus P1, puis des opérations d'accumulation ACC successives à l'issue de chaque nouvelle itération du premier processus P1, ceci afin d'obtenir K fois le premier signal filtré E1 sans utiliser de multiplicateur et en utilisant alors des opérations d'accumulation ACC successives jusqu'à obtenir K fois le premier signal filtré E1. Ce signal correspondant à K fois le premier signal filtré E1 est alors retranché au deuxième signal filtré E2 qui avait été initialement mémorisé, ceci pour délivrer le signal de sortie Ys.

Le tableau 1 ci-après donne alors des éléments de comparaison entre ces trois variantes de réalisation, étant observé que la durée de chaque processus P1, P2 correspond sensiblement à la somme d'une durée d'intégration qui est de l'ordre de 4 fois l'inverse de la fréquence cible Fw, soit environ 2 ns, et d'une durée de conversion analogique-numérique qui est de l'ordre de 3 ns, chaque processus P1, P2 présentant alors une durée d'environ 5 ns.

[Table 1]

|  | 1 ère variante | 2e variante | 3e variante |
|---|---|---|---|
| Durée du processus | ~5ns | ~10ns | ~(K+1)x5ns |
| Consommation | x 1 | x 1 | x (K+ 1)/2 |
| Surface occupée | x 2 | x 1 | x 1 |
| Gain rapport signal sur bruit | 0 | 0 | ~√K |

Ce tableau 1 montre alors que la première variante de réalisation est celle permettant d'offrir un débit maximum, la deuxième variante est celle permettant d'avoir un débit optimisé par rapport à la consommation électrique et à la surface occupée par un circuit de mise en oeuvre de cette variante ; et la troisième variante est celle permettant d'améliorer le rapport signal sur bruit.

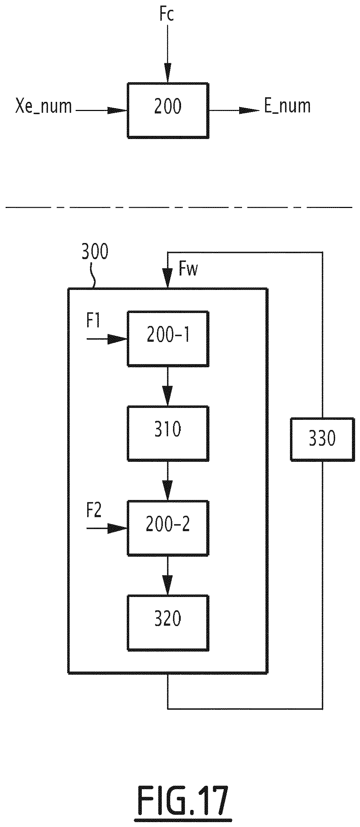

L'invention concerne également un procédé de traitement d'un signal numérique d'entrée Xe_num, tel que représenté sur l'organigramme de la figure 17, le signal numérique d'entrée Xe_num étant apte à être fourni par un convertisseur analogique-numérique connecté en sortie d'un capteur, non représenté, apte à recevoir le signal analogique d'entrée Xe.

Le procédé de traitement est mis en oeuvre par ordinateur et comprend une étape 200 de filtrage coupe-bande du signal numérique d'entrée Xe_num en un signal numérique filtré E_num, le signal numérique filtré E_num présentant en la fréquence de coupure Fc une amplitude atténuée par rapport à celle du signal d'entrée Xe_num.

Selon l'invention, l'étape de filtrage 200 comporte alors une intégration du signal d'entrée Xe_num lors de plusieurs fenêtres temporelles successives W1, W2 chaque fenêtre temporelle W1, W2 débutant en un instant temporel initial respectif et ayant une durée sensiblement égale à l'inverse de la fréquence de coupure Fc.

Comme décrit précédemment, les instants temporels initiaux d'au moins deux fenêtres distinctes sont séparés d'un décalage temporel de valeur supérieure ou égale à la durée prédéfinie de référence Df, telle que l'inverse de la fréquence de coupure Fc, et chaque intégration du signal numérique d'entrée Xe_num lors d'une fenêtre temporelle respective résulte en un signal numérique intermédiaire Si_num respectif.

L'étape de filtrage 200 comporte ensuite une sommation des signaux numériques intermédiaires Si_num pour obtenir ensuite le signal numérique filtré E_num, le signal numérique filtré E_num étant fonction de la somme des signaux numériques intermédiaires Si_num.

En complément, le procédé de traitement selon l'invention comprend un processus 300 de filtrage passe-bande du signal numérique d'entrée Xe_num en le signal numérique de sortie Ys_num, le signal numérique de sortie Ys_num présentant, en dehors de la bande de fréquences centrée autour de la fréquence cible Fw, une amplitude atténuée par rapport à celle du signal numérique d'entrée Xe_num.

Le processus de filtrage 300 comporte alors une mise en oeuvre initiale, notée 200-1, de l'étape de filtrage coupe-bande 200, avec la fréquence de coupure Fc égale à une première fréquence F1 parmi la première fréquence de coupure Fc1 et la deuxième fréquence de coupure Fc2, la première fréquence de coupure Fc1 étant sensiblement égale à la fréquence cible Fw, et la deuxième fréquence de coupure Fc2 étant distincte de la première fréquence de coupure Fc1, la deuxième fréquence de coupure Fc2 étant soit strictement inférieure à la fréquence cible Fw, soit strictement supérieure à ladite fréquence cible Fw.

Le processus de filtrage passe-bande 300 comporte ensuite une étape 310 de mémorisation du signal obtenu parmi un premier signal numérique filtré E1_num associé à la première fréquence de coupure Fc1 et un deuxième signal numérique filtré E2_num associé à la deuxième fréquence de coupure Fc2.

Le processus de filtrage passe-bande 300 comporte ensuite une mise en oeuvre ultérieure, notée 200-2, de l'étape de filtrage coupe-bande 200 avec la fréquence de coupure Fc égale à une deuxième fréquence F2 parmi la première fréquence de coupure Fc1 et la deuxième fréquence de coupure Fc2, c'est-à-dire égale à l'autre parmi la première fréquence de coupure Fc1 et la deuxième fréquence de coupure Fc2, afin d'obtenir l'autre signal parmi le premier signal numérique filtré E1_num et le deuxième signal numérique filtré E2_num.

Le processus de filtrage passe-bande 300 comporte enfin une étape 320 de génération du signal numérique de sortie Ys_num à partir de la combinaison des premier E1_num et deuxième E2_num signaux numériques filtrés. Lors de cette étape de génération 320, la combinaison des premier E1_num et deuxième E2_num signaux numériques filtrés est typiquement une combinaison linéaire. Cette combinaison linéaire vérifie par exemple les équations (5) et (6) précédentes.

En complément facultatif, le procédé de traitement selon l'invention comprend plusieurs itérations du processus de filtrage passe-bande 300 pour différente valeurs successives de la fréquence cible Fw jusqu'à détection d'une fréquence caractéristique du signal numérique d'entrée Xe_num, la fréquence caractéristique correspondant alors à la valeur courante de la fréquence cible Fw.

Selon ce complément facultatif, le procédé comprend alors à l'issue de chaque processus de filtrage passe-bande 300, une étape 330 de modification de la valeur de fréquence cible Fw. Lors de cette étape de modification 330, la valeur de la fréquence cible Fw est par exemple initialement égale à la valeur minimale de la fréquence cible Fw_min, puis est incrémentée du pas prédéfini de fréquence à chaque nouvelle itération, jusqu'à atteindre la valeur maximale de la fréquence cible Fw_max.

Ainsi, le filtre électronique coupe-bande 10 selon l'invention et le dispositif électronique de filtrage passe-bande 50 associé permettent d'effectuer le filtrage souhaité en un temps réduit, la durée de mise en oeuvre de chaque filtrage coupe-bande via l'intégration du signal d'entrée Xe lors de plusieurs fenêtres temporelles W1, W2 successives étant réduite à quelques périodes du signal visé, et typiquement de l'ordre de 5 ns.

Cette durée optimisée du filtrage coupe-bande selon l'invention permet alors d'accéder plus rapidement à l'information utile, de réduire la consommation électrique induite par un tel filtrage, notamment si ledit filtrage est intégré dans une architecture de type *duty-cycling*, la consommation du filtre coupe-bande 10 étant alors d'environ 1,5 mA pendant environ 5 ns, ce qui représente une efficacité de 7,5pJ/bit avec un débit en OOK de 200kbps.

Cette durée optimisée permet également d'améliorer le débit de données traité par de tels filtres et/ou d'augmenter un nombre d'objets interconnectés à de tels filtres.

Le gain du filtre coupe-bande 10 selon l'invention est en outre ajustable en modifiant l'un des paramètres de l'intégration fenêtrée, à savoir en modifiant la transconductance $g_m$ de l'intégration et/ou la capacité $C_{int}$ de l'intégration. Cette possibilité d'ajustement du gain est alors très utile dans un récepteur radio où il peut être nécessaire d'ajuster le gain pour d'une part ne pas saturer la chaîne de réception, et d'autre part, se placer à un niveau optimal de détection du signal visé.

La fréquence de coupure Fc du filtre coupe-bande 10 selon l'invention et/ou la fréquence cible Fw du dispositif de filtrage passe-bande 50 selon l'invention sont en outre facilement modifiables et reconfigurables de par le module de génération 14.

Le filtre électronique coupe-bande 10, et en particulier le dispositif de filtrage passe-bande 50, permettent également d'offrir un filtrage avec une sélectivité élevée comme cela ressort des figures 7 à 11, la sélectivité étant en outre une fonction croissante de la valeur du multiple K.

De plus, lorsque le dispositif de filtrage passe-bande 50 est utilisé avec deux canaux distincts, à savoir le premier canal CH1 et le deuxième canal CH2, le dispositif de filtrage passe-bande 50 ne nécessite pas de séparateur en entrée de par une impédance d'entrée suffisamment élevée, et ne nécessite également pas de combineur en sortie lorsque la recombinaison est faite numériquement via le module de génération 55.

## Revendications

1. Dispositif électronique de filtrage passe-bande (50), apte à recevoir un signal d'entrée (Xe) et à délivrer un signal de sortie (Ys) présentant, en dehors d'une bande de fréquences centrée autour d'une fréquence cible (Fw), une amplitude atténuée par rapport à celle du signal d'entrée (Xe), le dispositif (50) comprenant :

   - un premier filtre coupe-bande (10A), apte à recevoir le signal d'entrée (Xe) et à délivrer un premier signal filtré (E1) présentant, en une première fréquence de coupure (Fc1), une amplitude atténuée par rapport à celle du signal d'entrée (Xe), la première fréquence de coupure (Fc1) étant sensiblement égale à la fréquence cible (Fw),
   - un deuxième filtre coupe-bande (10B), apte à recevoir le signal d'entrée (Xe) et à délivrer un deuxième signal filtré (E2) présentant, en une deuxième fréquence de coupure (Fc2), une amplitude atténuée par rapport à celle du signal d'entrée (Xe), la deuxième fréquence de coupure (Fc2) étant distincte de la première fréquence de coupure (Fc1), la deuxième fréquence de coupure (Fc2) étant strictement inférieure ou bien strictement supérieure à la fréquence cible (Fw),
   - un module de génération (55) connecté en sortie des premier (10A) et deuxième (10B) filtres coupe-bande et configuré pour générer le signal de sortie (Ys) à partir d'une combinaison des premier (E1) et deuxième (E2) signaux filtrés, au moins l'un, de préférence chacun, des premier (10A) et deuxième (10B) filtres coupe-bande comprenant :

      + un module d'intégration (12) configuré pour effectuer une intégration du signal d'entrée lors de plusieurs fenêtres temporelles (W1, W2) successives, chaque fenêtre temporelle (W1, W2) débutant en un instant temporel initial respectif et ayant une durée sensiblement égale à l'inverse de la fréquence de coupure (Fc), les instants temporels initiaux d'au moins deux fenêtres distinctes (W1, W2) étant séparés d'un décalage temporel de valeur supérieure ou égale à une durée prédéfinie de référence (Df), chaque intégration du signal d'entrée (Xe) lors d'une fenêtre temporelle respective (W1, W2) résultant en un signal intermédiaire (Si) respectif,
+ un module de sommation (16) connecté en sortie du module d'intégration (12) et configuré pour sommer les signaux intermédiaires (Si) issus du module d'intégration (12), le signal filtré (E) étant fonction de la somme desdits signaux intermédiaires (Si).

**2.** Dispositif électronique de filtrage passe-bande (50), apte à recevoir un signal d'entrée (Xe) et à délivrer un signal de sortie (Ys) présentant, en dehors d'une bande de fréquences centrée autour d'une fréquence cible (Fw), une amplitude atténuée par rapport à celle du signal d'entrée (Xe), le dispositif (50) comprenant :

- un filtre coupe-bande (10), apte à recevoir le signal d'entrée (Xe) et à délivrer un signal filtré (E) présentant, en une fréquence de coupure (Fc), une amplitude atténuée par rapport à celle du signal d'entrée (Xe),
- un module de commande configuré pour :

+ commander le filtre coupe-bande (10) avec la fréquence de coupure (Fc) égale à l'une parmi une première fréquence de coupure (Fc1) et une deuxième fréquence de coupure (Fc2), et mémoriser le signal obtenu parmi un premier signal filtré (E1) associé à la première fréquence de coupure (Fc1) et un deuxième signal filtré (E2) associé à la deuxième fréquence de coupure (Fc2), la première fréquence de coupure (Fc1) étant sensiblement égale à la fréquence cible (Fw), la deuxième fréquence de coupure (Fc2) étant distincte de la première fréquence de coupure (Fc1), la deuxième fréquence de coupure (Fc2) étant strictement inférieure ou bien strictement supérieure à la fréquence cible (Fw) ; et
+ commander ensuite le filtre coupe-bande (10) avec la fréquence de coupure (Fc) égale à l'autre parmi la première fréquence de coupure (Fc1) et la deuxième fréquence de coupure (Fc2), afin d'obtenir l'autre signal parmi le premier signal filtré (E1) et le deuxième signal filtré (E2),

- un module de génération (55) connecté en sortie du module de commande et configuré pour générer le signal de sortie (Ys) à partir d'une combinaison des premier (E1) et deuxième (E2) signaux filtrés, le filtre coupe-bande (10) comprenant :

+ un module d'intégration (12) configuré pour effectuer une intégration du signal d'entrée lors de plusieurs fenêtres temporelles (W1, W2) successives, chaque fenêtre temporelle (W1, W2) débutant en un instant temporel initial respectif et ayant une durée sensiblement égale à l'inverse de la fréquence de coupure (Fc), les instants temporels initiaux d'au moins deux fenêtres distinctes (W1, W2) étant séparés d'un décalage temporel de valeur supérieure ou égale à une durée prédéfinie de référence (Df), chaque intégration du signal d'entrée (Xe) lors d'une fenêtre temporelle respective (W1, W2) résultant en un signal intermédiaire (Si) respectif,
+ un module de sommation (16) connecté en sortie du module d'intégration (12) et configuré pour sommer les signaux intermédiaires (Si) issus du module d'intégration (12), le signal filtré (E) étant fonction de la somme desdits signaux intermédiaires (Si).

**3.** Dispositif (50) selon la revendication 1 ou 2, dans lequel le module d'intégration (12) est configuré pour effectuer l'intégration du signal d'entrée (Xe) lors de No premières fenêtres temporelles (W1) successives, puis lors de Nb deuxièmes fenêtres temporelles (W2) successives, No et Nb étant chacun un nombre entier supérieur ou égal à 2, les instants temporels initiaux des No premières fenêtres (W1) étant tous inclus dans une première période temporelle de durée sensiblement égale à la durée de référence (Df), et les instants temporels initiaux des Nb deuxièmes fenêtres (W2) étant tous postérieurs à la première période temporelle ;

les instants temporels initiaux des No premières fenêtres (W1) étant de préférence régulièrement répartis au cours de la première période temporelle ;
les instants temporels initiaux des Nb deuxièmes fenêtres (W2) étant de préférence régulièrement répartis au cours d'une deuxième période temporelle, postérieure à la première période temporelle ;
la deuxième période temporelle étant de préférence encore de durée sensiblement égale à la durée de référence (Df).

**4.** Dispositif (50) selon l'une quelconque des revendications précédentes, dans lequel un module d'une fonction de transfert pour l'intégration du signal d'entrée (Xe) lors d'une fenêtre temporelle respective (W1, W2) vérifie l'équation suivante :

$$|G(f)| = \frac{\sqrt{2(1 - \cos(2\pi f T_{int}))}}{\frac{f}{F_{int}}}$$

où G représente le gain et f la fréquence,
$T_{int}$ représente la durée de la fenêtre temporelle respective (W1, W2) ; et
$F_{int}$ vérifie l'équation suivante :

$$F_{int} = \frac{g_m}{2\pi C_{int}}$$

avec $g_m$ représentant une transconductance de l'intégration, et.
$C_{int}$ représentant une capacité de l'intégration.

**5.** Dispositif (50) selon l'une quelconque des revendications précédentes, dans lequel le module d'intégration (12) comporte au moins une unité d'intégration (20), chaque unité d'intégration (20) étant connectée en entrée du module de sommation (16) et configurée pour effectuer une intégration du signal d'entrée (Xe) lors d'au moins une fenêtre temporelle (W1, W2) ;
le module d'intégration (12) comportant de préférence plusieurs unités d'intégration (20) agencées en parallèle les unes des autres, chacune étant configurée pour effectuer une intégration du signal d'entrée (Xe) lors d'une fenêtre temporelle (W1, W2) respective.

**6.** Dispositif (50) selon l'une quelconque des revendications précédentes, dans lequel le module de sommation (16) est un module numérique, et le module d'intégration (12) comporte au moins un convertisseur analogique-numérique (44), le signal d'entrée (Xe) étant un signal analogique ;

chaque unité d'intégration (20) comportant de préférence un étage analogique de conversion (40), un étage moyenneur (42) et un convertisseur analogique-numérique (44), et
un convertisseur analogique-numérique avec registre à approximations successives (46) formant de préférence encore l'étage moyenneur (42) et le convertisseur analogique-numérique (44).

**7.** Dispositif (50) selon l'une quelconque des revendications 1 à 5, dans lequel le module d'intégration (12) et le module de sommation (16) sont chacun un module analogique, le signal d'entrée (Xe) étant un signal analogique.

**8.** Dispositif (50) selon l'une quelconque des revendications précédentes, dans lequel la deuxième fréquence de coupure (Fc2) est sensiblement égale à deux tiers de la fréquence cible (Fw) ou bien sensiblement égale à deux fois la fréquence cible (Fw).

**9.** Dispositif (50) selon l'une quelconque des revendications précédentes, dans lequel la durée prédéfinie de référence (Df) est égale à l'inverse de la fréquence cible (Fw).

**10.** Dispositif (50) selon l'une quelconque des revendications précédentes, dans lequel la combinaison des premier (E1) et deuxième (E2) signaux filtrés est une combinaison linéaire,

la combinaison linéaire des premier (E1) et deuxième (E2) signaux filtrés vérifiant de préférence l'équation suivante :

$$Ys = E2 - K \cdot E1$$

où Ys représente le signal de sortie,
E1 représente le premier signal filtré,
E2 représente le deuxième signal filtré,
K est un nombre entier supérieur ou égal à 1 ;
K étant de préférence une puissance de 2 et s'écrivant alors :

$$K = 2^P$$

avec P entier positif.

**11.** Système de détection de fréquence (60), notamment pour récepteur radio, le système (60) comprenant :

- un dispositif électronique de filtrage passe-bande (50), apte à recevoir un signal d'entrée (Xe) et à délivrer un signal de sortie (Ys) présentant, en dehors d'une bande de fréquences centrée autour d'une fréquence cible (Fw), une amplitude atténuée par rapport à celle du signal d'entrée (Xe), et
- un dispositif électronique de pilotage (65), apte à faire varier la valeur de la fréquence cible (Fw) du dispositif de filtrage passe-bande (50) jusqu'à détection d'une fréquence caractéristique du signal d'entrée (Xe), la fréquence caractéristique correspondant alors à la valeur courante de la fréquence cible (Fw),

**caractérisé en ce que** le dispositif électronique de filtrage passe-bande (50) est selon l'une quelconque des revendications précédentes.

**12.** Récepteur radio comprenant un système de détection de fréquence (60), **caractérisé en ce que** le système de détection de fréquence (60) est selon la revendication précédente.

**13.** Procédé de traitement d'un signal numérique d'entrée (Xe_num), le signal numérique d'entrée (Xe_num) étant apte à être fourni par un convertisseur analogique-numérique connecté en sortie d'un capteur apte à recevoir un signal analogique d'entrée (Xe), le procédé étant mis en oeuvre par ordinateur et comprenant :

- une étape (200) de filtrage coupe-bande du signal numérique d'entrée (Xe_num) en un signal numérique filtré (E_num), le signal numérique filtré (E_num) présentant, en une fréquence de coupure (Fc), une amplitude atténuée par rapport à celle du signal numérique d'entrée (Xe_num),

l'étape de filtrage coupe-bande (200) comportant :

- une intégration du signal numérique d'entrée (Xe_num) lors de plusieurs fenêtres temporelles (W1, W2) successives, chaque fenêtre temporelle (W1, W2) débutant en un instant temporel initial respectif et ayant une durée sensiblement égale à l'inverse de la fréquence de coupure (Fc), les instants temporels initiaux d'au moins deux fenêtres distinctes (W1, W2) étant séparés d'un décalage temporel de valeur supérieure ou égale à une durée prédéfinie de référence (Df), chaque intégration du signal numérique d'entrée (Xe_num) lors d'une fenêtre temporelle (W1, W2) respective résultant en un signal numérique intermédiaire (Si_num) respectif, et
- une sommation des signaux numériques intermédiaires (Si_num), le signal numérique filtré (E_num) étant fonction de la somme desdits signaux numériques intermédiaires (Si_num) ;

le procédé comprenant un processus (300) de filtrage passe-bande du signal numérique d'entrée (Xe_num) en un signal numérique de sortie (Ys_num), le signal numérique de sortie (Ys_num) présentant, en dehors d'une bande de fréquences centrée autour d'une fréquence cible (Fw), une amplitude atténuée par rapport à celle du signal numérique d'entrée (Xe_num), le processus de filtrage passe-bande (300) comportant :

- une mise en oeuvre initiale (200-1) de l'étape de filtrage coupe-bande (200) avec la fréquence de coupure (Fc) égale à l'une parmi une première fréquence de coupure (Fc1) et une deuxième fréquence de coupure (Fc2), la première fréquence de coupure (Fc1) étant sensiblement égale à la fréquence cible (Fw), la deuxième fréquence de coupure (Fc2) étant distincte de la première fréquence de coupure (Fc1), la deuxième fréquence de coupure (Fc2) étant strictement inférieure ou bien strictement supérieure à la fréquence cible (Fw) ;
- une étape (310) de mémorisation du signal obtenu parmi un premier signal numérique filtré (E1_num) associé à la première fréquence de coupure (Fc1) et un deuxième signal numérique filtré (E2_num) associé à la deuxième fréquence de coupure (Fc2), et
- une mise en oeuvre ultérieure (200-2) de l'étape de filtrage coupe-bande (200) avec la fréquence de coupure (Fc) égale à l'autre parmi la première fréquence de coupure (Fc1) et la deuxième fréquence de coupure (Fc2), afin d'obtenir l'autre signal parmi le premier signal numérique filtré (E1_num) et le deuxième signal numérique filtré (E2_num),
- une étape (320) de génération du signal numérique de sortie (Ys_num) à partir d'une combinaison des premier (E1_num) et deuxième (E2_num) signaux numériques filtrés.

**14.** Procédé selon la revendication 13, dans lequel le procédé comprend plusieurs itérations du processus de filtrage passe-bande (300) pour différentes valeurs successives de la fréquence cible (Fw) jusqu'à détection d'une fréquence caractéristique du signal d'entrée (Xe), la fréquence caractéristique correspondant alors à une valeur courante de la fréquence cible (Fw).

**Patentansprüche**

**1.** Elektronische Bandpassfiltervorrichtung (50), die geeignet ist, um ein Eingangssignal (Xe) zu empfangen und ein Ausgangssignal (Ys) zu liefern, das außerhalb eines Frequenzbandes, das um eine Zielfrequenz (Fw) zentriert ist, eine gedämpfte Amplitude in Bezug auf die des Eingangssignals (Xe) aufweist, die Vorrichtung (50) umfassend:

- ein erstes Bandsperrfilter (10A), das geeignet ist, um das Eingangssignal (Xe) zu empfangen und ein erstes gefiltertes Signal (E1) zu liefern, das bei einer ersten Grenzfrequenz (Fc1) eine gedämpfte Amplitude in Bezug auf die des Eingangssignals (Xe) aufweist, wobei die erste Grenzfrequenz (Fc1) im Wesentlichen gleich wie die Zielfrequenz (Fw) ist,
- ein zweites Bandsperrfilter (10B), das das Eingangssignal (Xe) empfangen und ein zweites gefiltertes Signal (E2) liefern kann, das bei einer zweiten Grenzfrequenz (Fc2) eine gedämpfte Amplitude in Bezug auf die des Eingangssignals (Xe) aufweist, wobei die zweite Grenzfrequenz (Fc2) von der ersten Grenzfrequenz (Fc1) verschieden ist, wobei die zweite Grenzfrequenz (Fc2) strikt unterhalb oder auch strikt oberhalb der Zielfrequenz (Fw) ist,
- ein Erzeugungsmodul (55), das mit dem Ausgang des ersten (10A) und des zweiten (10B) Bandsperrfilters verbunden und konfiguriert ist, um das Ausgangssignal (Ys) aus einer Kombination des ersten (E1) und des zweiten (E2) gefilterten Signals zu erzeugen,

mindestens eines, vorzugsweise jedes von dem ersten (10A) und dem zweiten (10B) Bandsperrfilter, umfassend:

+ ein Integrationsmodul (12), das konfiguriert ist, um eine Integration des Eingangssignals während mehrerer aufeinanderfolgender Zeitfenster (W1, W2) durchzuführen, wobei jedes Zeitfenster (W1, W2) in einem jeweiligen Anfangszeitmoment beginnt und eine Dauer aufweist, die im Wesentlichen gleich wie der Kehrwert der Grenzfrequenz (Fc) ist, wobei die Anfangszeitpunkte von mindestens zwei verschiedenen Fenstern (W1, W2) durch eine Zeitverschiebung getrennt sind, deren Wert größer als oder gleich wie eine vordefinierte Referenzdauer (Df) ist, wobei jede Integration des Eingangssignals (Xe) während eines jeweiligen Zeitfensters (W1, W2) in einem jeweiligen Zwischensignal (Si) resultiert,
+ ein Summationsmodul (16), das mit dem Ausgang des Integrationsmoduls (12) verbunden und konfiguriert ist, um die von dem Integrationsmodul (12) ausgegebenen Zwischensignale (Si) zu summieren, wobei das gefilterte Signal (E) abhängig von der Summe der Zwischensignale (Si) ist.

**2.** Elektronische Bandpassfiltervorrichtung (50), die geeignet ist, um ein Eingangssignal (Xe) zu empfangen und ein Ausgangssignal (Ys) zu liefern, das außerhalb eines Frequenzbandes, das um eine Zielfrequenz (Fw) zentriert ist, eine gedämpfte Amplitude in Bezug auf die des Eingangssignals (Xe) aufweist, die Vorrichtung (50) umfassend:

- ein Bandsperrfilter (10), das das Eingangssignal (Xe) empfangen und ein gefiltertes Signal (E) liefern kann, das bei einer Grenzfrequenz (Fc) eine gedämpfte Amplitude in Bezug auf die des Eingangssignals (Xe) aufweist,
- ein Steuermodul, das zu Folgendem konfiguriert ist:

+ Steuern des Bandsperrfilters (10) mit der Grenzfrequenz (Fc) gleich einer von einer ersten Grenzfrequenz (Fc1) und einer zweiten Grenzfrequenz (Fc2), und Speichern des erlangten Signals unter einem ersten gefilterten Signal (E1), das mit der ersten Grenzfrequenz (Fc1) assoziiert ist, und einem zweiten gefilterten Signal (E2), das mit der zweiten Grenzfrequenz (Fc2) assoziiert ist, wobei die erste Grenzfrequenz (Fc1) im Wesentlichen gleich wie die Zielfrequenz (Fw) ist, die zweite Grenzfrequenz (Fc2) von der ersten Grenzfrequenz (Fc1) verschieden ist, die zweite Grenzfrequenz (Fc2) strikt unterhalb oder aber strikt oberhalb der Zielfrequenz (Fw) ist; und
+ dann Steuern des Bandsperrfilters (10) mit der Grenzfrequenz (Fc) gleich der anderen der ersten Grenzfrequenz (Fc1) und der zweiten Grenzfrequenz (Fc2), um das andere von dem ersten gefilterten Signal (E1) und dem zweiten gefilterten Signal (E2) zu erlangen,

- ein Generierungsmodul (55), das mit dem Ausgang des Steuermoduls verbunden und konfiguriert ist, um das Ausgangssignal (Ys) aus einer Kombination des ersten (E1) und des zweiten (E2) gefilterten Signals zu erzeugen,

das Bandsperrfilter (10) umfassend:

+ ein Integrationsmodul (12), das konfiguriert ist, um eine Integration des Eingangssignals während mehrerer aufeinanderfolgender Zeitfenster (W1, W2) durchzuführen, wobei jedes Zeitfenster (W1, W2) in einem jeweiligen Anfangszeitmoment beginnt und eine Dauer aufweist, die im Wesentlichen gleich wie der Kehrwert der Grenzfrequenz (Fc) ist, wobei die Anfangszeitpunkte von mindestens zwei verschiedenen Fenstern (W1, W2) durch eine Zeitverschiebung getrennt sind, deren Wert größer als oder gleich wie eine vordefinierte Referenzdauer (Df) ist, wobei jede Integration des Eingangssignals (Xe) während eines jeweiligen Zeitfensters (W1, W2) in einem jeweiligen Zwischensignal (Si) resultiert,
+ ein Summationsmodul (16), das mit dem Ausgang des Integrationsmoduls (12) verbunden und konfiguriert ist, um die von dem Integrationsmodul (12) ausgegebenen Zwischensignale (Si) zu summieren, wobei das gefilterte Signal (E) abhängig von der Summe der Zwischensignale (Si) ist.

3. Vorrichtung (50) nach Anspruch 1 oder 2, wobei das Integrationsmodul (12) konfiguriert ist, um die Integration des Eingangssignals (Xe) während No aufeinanderfolgender erster Zeitfenster (W1) und dann während Nb aufeinanderfolgender zweiter Zeitfenster (W2) durchzuführen, wobei No und Nb jeweils eine ganze Zahl größer als oder gleich wie 2 sind, wobei die Anfangszeitpunkte der No ersten Fenster (W1) alle in einer ersten Zeitperiode beinhaltet sind, deren Dauer im Wesentlichen gleich wie die Referenzdauer (Df) ist, und wobei die Anfangszeitpunkte der Nb zweiten Fenster (W2) alle nach der ersten Zeitperiode sind;

wobei die Anfangszeitpunkte der No ersten Fenster (W1) vorzugsweise gleichmäßig über die erste Zeitperiode verteilt sind;
wobei die Anfangszeitpunkte der Nb zweiten Fenster (W2) vorzugsweise gleichmäßig über eine zweite Zeitperiode verteilt sind, die nach der ersten Zeitperiode ist;
wobei die zweite Zeitperiode vorzugsweise noch eine Dauer aufweist, die im Wesentlichen gleich wie die Referenzdauer (Df) ist.

4. Vorrichtung (50) nach einem der vorherigen Ansprüche, wobei ein Modul einer Übertragungsfunktion zur Integration des Eingangssignals (Xe) während eines jeweiligen Zeitfensters (W1, W2) die folgende Gleichung erfüllt:

$$|G(f)| = \frac{\sqrt{2(1 - \cos(2\pi f T_{int}))}}{\frac{f}{F_{int}}}$$

wobei G die Verstärkung und f die Frequenz darstellt,
$T_{int}$ die Dauer des jeweiligen Zeitfensters (W1, W2) darstellt; und
$F_{int}$ die folgende Gleichung überprüft:

$$F_{int} = \frac{g_m}{2\pi C_{int}}$$

wobei $g_m$ eine Transkonduktanz der Integration darstellt, und
$C_{int}$ eine Integrationsfähigkeit darstellt.

5. Vorrichtung (50) nach einem der vorherigen Ansprüche, wobei das Integrationsmodul (12) mindestens eine Integrationseinheit (20) umfasst, wobei jede Integrationseinheit (20) mit dem Eingang des Summationsmoduls (16) verbunden und konfiguriert ist, um während mindestens eines Zeitfensters (W1, W2) eine Integration des Eingangssignals (Xe) durchzuführen;
wobei das Integrationsmodul (12) vorzugsweise mehrere parallel zueinander angeordnete Integrationseinheiten (20) umfasst, die jeweils konfiguriert sind, um während eines jeweiligen Zeitfensters (W1, W2) eine Integration des Eingangssignals (Xe) durchzuführen.

6. Vorrichtung (50) nach einem der vorherigen Ansprüche, wobei das Summationsmodul (16) ein digitales Modul ist und das Integrationsmodul (12) mindestens einen Analog-Digital-Wandler (44) umfasst, wobei das Eingangssignal (Xe) ein analoges Signal ist;

   jede Integrationseinheit (20) vorzugsweise umfassend eine analoge Wandlerstufe (40), eine Mittelwertbildungsstufe (42) und einen Analog-Digital-Wandler (44), und
   einen Analog-Digital-Wandler mit Register mit sukzessiver Approximation (46), der vorzugsweise noch die Mittelwertbildungsstufe (42) und den Analog-Digital-Wandler (44) bildet.

7. Vorrichtung (50) nach einem der Ansprüche 1 bis 5, wobei das Integrationsmodul (12) und das Summationsmodul (16) jeweils ein analoges Modul sind, wobei das Eingangssignal (Xe) ein analoges Signal ist.

8. Vorrichtung (50) nach einem der vorherigen Ansprüche, wobei die zweite Grenzfrequenz (Fc2) im Wesentlichen gleich wie zwei Drittel der Zielfrequenz (Fw) oder im Wesentlichen gleich wie das Doppelte der Zielfrequenz (Fw) ist.

9. Vorrichtung (50) nach einem der vorherigen Ansprüche, wobei die vordefinierte Referenzdauer (Df) gleich wie der Kehrwert der Zielfrequenz (Fw) ist.

10. Vorrichtung (50) nach einem der vorherigen Ansprüche, wobei die Kombination des ersten (E1) und des zweiten (E2) gefilterten Signals eine lineare Kombination ist,

    wobei die lineare Kombination des ersten (E1) und des zweiten (E2) gefilterten Signals vorzugsweise die folgende Gleichung erfüllt:

$$Ys = E2 - K \cdot E1$$

    wobei Ys das Ausgangssignal darstellt,
    E1 das erste gefilterte Signal darstellt,
    E2 das zweite gefilterte Signal darstellt,
    K eine ganze Zahl größer als oder gleich wie 1 ist;
    wobei K vorzugsweise eine Potenz von 2 ist und dann wie folgt geschrieben wird:

$$K = 2^P$$

    wobei P eine positive ganze Zahl ist.

11. Frequenzerfassungssystem (60), insbesondere für Funkempfänger, das System (60) umfassend:

    - eine elektronische Bandpassfiltervorrichtung (50), die geeignet ist, um ein Eingangssignal (Xe) zu empfangen und ein Ausgangssignal (Ys) zu liefern, das außerhalb eines Frequenzbandes, das um eine Zielfrequenz (Fw) zentriert ist, eine gedämpfte Amplitude in Bezug auf die des Eingangssignals (Xe) aufweist, und
    - eine elektronische Steuervorrichtung (65), die geeignet ist, um den Wert der Zielfrequenz (Fw) der Bandpassfiltervorrichtung (50) bis zu der Erfassung einer charakteristischen Frequenz des Eingangssignals (Xe) zu variieren, wobei die charakteristische Frequenz dann dem aktuellen Wert der Zielfrequenz (Fw) entspricht,

    **dadurch gekennzeichnet, dass** die elektronische Bandpassfiltervorrichtung (50) gemäß einem der vorherigen Ansprüche ist.

12. Funkempfänger, umfassend ein Frequenzerfassungssystem (60), **dadurch gekennzeichnet, dass** das Frequenzerfassungssystem (60) gemäß dem vorherigen Anspruch ist.

13. Verfahren zur Verarbeitung eines digitalen Eingangssignals (Xe_num), wobei das digitale Eingangssignal (Xe_num) geeignet ist, um von einem Analog-Digital-Wandler geliefert zu werden, der mit dem Ausgang eines Sensors verbunden ist, der geeignet ist, ein analoges Eingangssignal (Xe) zu empfangen, wobei das Verfahren computerimplementiert ist und Folgendes umfasst:

- einen Schritt (200) einer Bandsperrfilterung des digitalen Eingangssignals (Xe_num) in ein gefiltertes digitales Signal (E num), wobei das gefilterte digitale Signal (E num) bei einer Grenzfrequenz (Fc) eine gedämpfte Amplitude in Bezug auf die des digitalen Eingangssignals (Xe_num) aufweist,

der Schritt eines Bandsperrfilterns (200) umfassend:

- eine Integration des digitalen Eingangssignals (Xe_num) während mehrerer aufeinanderfolgender Zeitfenster (W1, W2), wobei jedes Zeitfenster (W1, W2) in einem jeweiligen Anfangszeitmoment beginnt und eine Dauer aufweist, die im Wesentlichen gleich wie der Kehrwert der Grenzfrequenz (Fc) ist, wobei die Anfangszeitmomente von mindestens zwei verschiedenen Fenstern (W1, W2) durch einen Zeitversatz getrennt sind, dessen Wert größer als oder gleich wie eine vordefinierte Referenzdauer (Df) ist, wobei jede Integration des digitalen Eingangssignals (Xe_num) während eines jeweiligen Zeitfensters (W1, W2) in einem jeweiligen digitalen Zwischensignal (Si_num) resultiert, und
- eine Summierung der digitalen Zwischensignale (Si_num), wobei das gefilterte digitale Signal (E num) abhängig von der Summe der digitalen Zwischensignale (Si_num) ist;

das Verfahren umfassend

einen Prozess (300) zum Bandpassfiltern

des digitalen Eingangssignals (Xe_num) in ein digitales Ausgangssignal (Ys_num), wobei das digitale Ausgangssignal (Ys_num) außerhalb eines Frequenzbands, das um eine Zielfrequenz (Fw) zentriert ist, eine gedämpfte Amplitude in Bezug auf die des digitalen Eingangssignals (Xe_num) aufweist, der Bandpassfilterprozess (300) umfassend:

- eine anfängliche Implementierung (200-1) des Schritts der Bandsperrfilterung (200) mit der Grenzfrequenz (Fc), die gleich wie eine von einer ersten Grenzfrequenz (Fc1) und einer zweiten Grenzfrequenz (Fc2) ist, wobei die erste Grenzfrequenz (Fc1) im Wesentlichen gleich wie die Zielfrequenz (Fw) ist, die zweite Grenzfrequenz (Fc2) von der ersten Grenzfrequenz (Fc1) verschieden ist, wobei die zweite Grenzfrequenz (Fc2) strikt kleiner oder strikt größer als die Zielfrequenz (Fw) ist;
- einen Schritt (310) eines Speicherns des erlangten Signals aus einem ersten gefilterten digitalen Signal (E1_num), das mit der ersten Grenzfrequenz (Fc1) assoziiert ist, und einem zweiten gefilterten digitalen Signal (E2_num), das mit der zweiten Grenzfrequenz (Fc2) assoziiert ist, und
- ein nachfolgendes Durchführen (200-2) des Schritts eines Bandsperrfilterns (200) mit der Grenzfrequenz (Fc), die gleich wie die andere von der ersten Grenzfrequenz (Fc1) und der zweiten Grenzfrequenz (Fc2) ist, um das andere von dem ersten gefilterten digitalen Signal (E1_num) und dem zweiten gefilterten digitalen Signal (E2_num) zu erlangen,
- einen Schritt (320) eines Erzeugens des digitalen Ausgangssignals (Ys_num) aus einer Kombination des ersten (E1_num) und des zweiten (E2_num) gefilterten digitalen Signals.

14. Verfahren nach Anspruch 13, wobei das Verfahren mehrere Iterationen des Bandpassfilterprozesses (300) für verschiedene aufeinanderfolgende Werte der Zielfrequenz (Fw) umfasst, bis eine charakteristische Frequenz des Eingangssignals (Xe) erfasst wird, wobei die charakteristische Frequenz dann einem aktuellen Wert der Zielfrequenz (Fw) entspricht.

## Claims

1. An electronic band-pass filtering device (50) able to receive an input signal (Xe) and deliver an output signal (Ys) having an amplitude, outside a frequency band centered around a target frequency (Fw), that is attenuated relative to that of the input signal (Xe), the device (50) comprising:

- a first notch filter (10A), able to receive the input signal (Xe) and deliver a first filtered signal (E1) having an amplitude, at a first cutoff frequency (Fc1), that is attenuated in relation to that of the input signal (Xe), the first cutoff frequency (Fc1) being substantially equal to the target frequency (Fw),
- a second notch filter (10B), able to receive the input signal (Xe) and deliver a second filtered signal (E2) having an amplitude, at a second cutoff frequency (Fc2), that is attenuated in relation to that of the input signal (Xe), the second cutoff frequency (Fc2) being distinct from the first cutoff frequency (Fc1), the second cutoff frequency (Fc2) being strictly less than, or strictly greater than the target frequency (Fw)

- a generation module (55) connected to the output of the first (10A) and second (10B) notch filters, configured to generate the output signal (Ys) from a combination of the first (E1) and second (E2) filtered signals,

at least one, preferably each, of the first (10A) and second (10B) notch filters comprising:

+ an integration module (12) configured to integrate the input signal during several successive time windows (W1, W2), each time window (W1, W2) starting at a respective initial instant in time and having a duration substantially equal to the inverse of the cutoff frequency (Fc), the initial instants in time of at least two distinct windows (W1, W2) being separated by a time shift of value greater than or equal to a predefined reference duration (Df), each integration of the input signal (Xe) during a respective time window (W1, W2) resulting in a respective intermediate signal (Si),
+ a summing module (16) connected to the output of the integration module (12), configured to add up the intermediate signals (Si) coming from the integration module (12), the filtered signal (E) being a function of the sum of said intermediate signals (Si).

2. An electronic band-pass filtering device (50), able to receive an input signal (Xe) and deliver an output signal (Ys) having an amplitude, outside a frequency band centered around a target frequency (Fw), that is attenuated in relation to that of the input signal (Xe), the device (50) comprising:

- a notch filter (10), able to receive the input signal (Xe) and deliver a filtered signal (E) having an amplitude, at a cutoff frequency (Fc), attenuated in relation to that of the input signal (Xe).
- a control module configured to:

+ control the notch filter (10) with the cutoff frequency (Fc) equal to one of a first cutoff frequency (Fc1) and a second cutoff frequency (Fc2), and store the signal obtained among a first filtered signal (E1) related to the first cutoff frequency (Fc1) and a second filtered signal (E2) related to the second cutoff frequency (Fc2), the first cutoff frequency (Fc1) being substantially equal to the target frequency (Fw), the second cutoff frequency (Fc2) being distinct from the first cutoff frequency (Fc1), the second cutoff frequency (Fc2) being strictly lower than or strictly higher than the target frequency (Fw); and
+ then control the notch filter (10) with the cutoff frequency (Fc) equal to the other of the first cutoff frequency (Fc1) and the second cutoff frequency (Fc2), in order to obtain the other of the first filtered signal (E1) and the second filtered signal (E2)

- a generation module (55), connected to the output of the control module and configured to generate the output signal (Ys) from a combination of the first (E1) and second (E2) filtered signals,

the notch filter (10) comprising:

+ an integration module (12), configured to integrate of the input signal during several successive time windows (W1, W2), each time window (W1, W2) starting at a respective initial instant in time and having a duration substantially equal to the inverse of the cutoff frequency (Fc), with the initial instants in time of at least two distinct windows (W1, W2) separated by a time shift of value greater than or equal to a predefined reference duration (Df), each integration of the input signal (Xe) during a respective time window (W1, W2) resulting in a respective intermediate signal (Si),
+ a summing module (16), connected to the output of the integration module (12) and configured to add up the intermediate signals (Si) coming from the integration module (12), the filtered signal (E) being a function of the sum of said intermediate signals (Si).

3. The device (50) according to claim 1 or 2, wherein the integration module (12) is configured to integrate the input signal (Xe) during No first successive time windows (W1), thus during Nb second successive time windows (W2), with No and Nb each being an integer greater than or equal to 2, the initial instants in time of the No first windows (W1) all included in a first time period of duration substantially equal to the reference duration (Df), and the initial instants in time of the Nb second windows (W2) all subsequent to the first time period;

the initial instants in time of the No first windows (W1) preferably being regularly distributed during the first time period;
the initial instants in time of the Nb second windows (W2) preferably being regularly distributed during a second time period, subsequent to the first time period;

the second time period more preferably being substantially equal in duration to the reference duration (Df).

4. The device (50) according to any of the preceding claims, wherein a transfer function module for integrating the input signal (Xe) during a respective time window (W1, W2) satisfies the following equation:

$$|G(f)| = \frac{\sqrt{2(1 - \cos(2\pi f T_{int}))}}{\frac{f}{F_{int}}}$$

where G represents the gain and f the frequency,
$T_{int}$ represents the duration of the respective time window (W1, W2); and
$F_{int}$ satisfies the following equation:

$$F_{int} = \frac{g_m}{2\pi C_{int}}$$

with $g_m$ representing a transconductance of the integration, and.
$C_{int}$ representing a capacitance of the integration.

5. The device (50) according to any one of the preceding claims, wherein the integration module (12) comprises at least one integration unit (20), each integration unit (20) being connected to the input of the summing module (16) and configured to perform an integration of the input signal (Xe) during at least one time window (W1, W2);
the integration module (12) preferably comprising multiple integration units (20) arranged in parallel with each other, each of which is configured to perform an integration of the input signal (Xe) during a respective time window (W1, W2).

6. The device (50) according to any one of the preceding claims, wherein the summing module (16) is a digital module, and the integration module (12) comprises at least one analog-to-digital converter (44), the input signal (Xe) being an analog signal;

each integration unit (20) preferably comprising an analog conversion stage (40), an averaging stage (42) and an analog-to-digital converter (44), and
an analog-to-digital converter with successive approximation register (46) preferably also forming the averaging stage (42) and the analog-to-digital converter (44).

7. The device (50) according to any one of claims 1 to 5, wherein the integration module (12) and the summing module (16) are each an analog module, the input signal (Xe) being an analog signal.

8. The device (50) according to any one of the preceding claims, wherein the second cutoff frequency (Fc2) is substantially equal to two-thirds of the target frequency (Fw) or substantially equal to twice the target frequency (Fw).

9. The device (50) according to any one of the preceding claims, wherein the predefined reference duration (Df) is equal to the inverse of the target frequency (Fw).

10. The device (50) according to any one of the preceding claims, wherein the combination of the first (E1) and second (E2) filtered signals is a linear combination,

the linear combination of the first (E1) and second (E2) filtered signals preferably satisfying the following equation:

$$Ys = E2 - K \cdot E1$$

where Ys represents the output signal,
E1 represents the first filtered signal,
E2 represents the second filtered signal,
K is an integer greater than or equal to 1;
K is preferably a power of 2 and is written as:

$$K = 2^P$$

with P a positive integer.

11. A frequency detection system (60), in particular for a radio receiver, the system (60) comprising:

- an electronic band-pass filtering device (50), able to receive an input signal (Xe) and deliver an output signal (Ys) having an amplitude, outside a frequency band centered around a target frequency (Fw), attenuated relative to that of the input signal (Xe), and
- an electronic control device (65), able to vary the value of the target frequency (Fw) of the band-pass filtering device (50) until a characteristic frequency of the input signal (Xe) is detected, the characteristic frequency thus corresponding to the current value of the target frequency (Fw),

**characterized in that** the electronic band-pass filtering device (50) is according to any of the preceding claims.

12. A radio receiver comprising a frequency detection system (60), **characterized in that** the frequency detection system (60) is according to the preceding claim.

13. A method for processing an input digital signal (Xe_num), the input digital signal (Xe_num) being able to be supplied by an analog-to-digital converter connected to the output of a sensor able to receive an input analog signal (Xe), the method being implemented by computer and comprising:

- a step (200) of notch filtering the input digital signal (Xe_num) into a filtered digital signal (E_num), the filtered digital signal (E_num) having an amplitude, at a cutoff frequency (Fc), attenuated relative to that of the input digital signal (Xe_num),

the notch filtering step (200) comprising:

- an integration of the input digital signal (Xe_num) during several successive time windows (W1, W2), each time window (W1, W2) starting at a respective initial instant in time and having a duration substantially equal to the inverse of the cutoff frequency (Fc), the initial instants in time of at least two distinct windows (W1, W2) being separated by a time shift of value greater than or equal to a predefined reference duration (Df), each integration of the input digital signal (Xe_num) during a respective time window (W1, W2) resulting in a respective intermediate digital signal (Si_num), and
- a summing of the intermediate digital signals (Si_num), the filtered digital signal (E_num) being a function of the sum of said intermediate digital signals (Si_num);

the method comprising a band-pass filtering process (300) for filtering the input digital signal (Xe_num) into an output digital signal (Ys_num), the output digital signal (Ys_num) having an amplitude, outside a frequency band centered around a target frequency (Fw), that is attenuated relative to that of the input digital signal (Xe_num), the band-pass filtering process (300) comprising:

- an initial implementation (200-1) of the notch filtering step (200) with the cutoff frequency (Fc) equal to one of a first cutoff frequency (Fc1) and a second cutoff frequency (Fc2), the first cutoff frequency (Fc1) being substantially equal to the target frequency (Fw) the second cutoff frequency (Fc2) being distinct from the first cutoff frequency (Fc1), the second cutoff frequency (Fc2) being strictly lower or strictly higher than the target frequency (Fw);
- a step (310) of storing the signal obtained among a first filtered digital signal (E1_num) related to the first cutoff frequency (Fc1) and a second filtered digital signal (E2_num) related to the second cutoff frequency (Fc2), and
- a subsequent implementation (200-2) of the notch filtering step (200) with the cutoff frequency (Fc) equal to the other of the first cutoff frequency (Fc1) and the second cutoff frequency (Fc2), in order to obtain the other of the first filtered digital signal (E1_num) and the second filtered digital signal (E2_num)
- a step (320) of generating the output digital signal (Ys_num) from a combination of the first (E1_num) and second (E2_num) filtered digital signals.

14. The method according to claim 13, wherein the method comprises multiple iterations of the band-pass filtering process (300) for different successive values of the target frequency (Fw) until a characteristic frequency of the input signal (Xe) is detected, the characteristic frequency thus corresponding to a current value of the target frequency (Fw).

FIG.1

## FIG.2

FIG.3

$$1/Fc$$

Xe

INT + ADC ⟩ 20

RECONF

Si

MEM

$$P/Fc + 1/(Fc*No)$$

INT + ADC ⟩ 20

RECONF

Si

ACC
MEM

$$2*[P/Fc + 1/(Fc*No)]$$

INT + ADC ⟩ 20

RECONF

$$(No + Nb-1)*[P/Fc + 1/(Fc*No)]$$

INT + ADC ⟩ 20

Si

ACC

E

## FIG.4

**FIG.5**

**FIG.6**

FIG.7

35

FIG.8

# FIG.9

CH1

&

CH2 A

No=4 / Nb=4 / ADC 6 bits

CH1
&
CH2 B

1/Fw

1/(2Fw)

CH1 & CH2 No=4 / Nb=4 / ADC 6 bits

ED1 Max

ED1 *

ED1 Min

ED2 Max

ED2 *

ED2 Min

ED

F (MHz)

## FIG.10

# FIG.11

CH1

&

CH2 B

No=4 / Nb=4 / ADC 6 bits

# FIG.12

FIG.13

**FIG.14**

# FIG.15

FIG.16

FIG.17

## RÉFÉRENCES CITÉES DANS LA DESCRIPTION

**Documents brevets cités dans la description**

- US 9407482 B2

**Littérature non-brevet citée dans la description**

- **HASAN.** Tunable N-Path RF Front-end Filter with an Adaptive Integrated Notch for FDDICo-Existence. IEEE, 2012

- **DARVISHI.** Widely Tunable 4th Order Switched Gm-C Band-Pass Filter Based on N-Path Filters. IEEE, 2012